# EUROPEAN PATENT SPECIFICATION

(11) **EP 4 328 970 B1**
(45) Date of publication and mention of the grant of the patent: **03.12.2025**
(21) Application number: 23192729.4
(22) Date of filing: 22.08.2023
(51) Int. Cl.: H10H 29/30, H10H 29/80, H10H 29/851, H10H 29/85, H10H 29/41

(54) **DISPLAY DEVICE AND METHOD OF FABRICATING THE SAME**
ANZEIGEVORRICHTUNG UND VERFAHREN ZU IHRER HERSTELLUNG
DISPOSITIF D'AFFICHAGE ET SON PROCÉDÉ DE FABRICATION

(30) Priority: 23.08.2022 KR 20220105701
(43) Date of publication of application: 28.02.2024
(73) Proprietor: Samsung Display Co., Ltd., Yongin-si, Gyeonggi-do 17113 (KR)
(72) Inventor: LEE, Ji Hye, 17113 Yongin-si (KR); KIM, Kyung Bae, 17113 Yongin-si (KR); KIM, Dong Woo, 17113 Yongin-si (KR); PARK, Do Yeong, 17113 Yongin-si (KR)
(74) Representative: Walaski, Jan Filip

(56) References cited:
- US-A1- 2008 303 424
- US-A1- 2020 301 197
- US-A1- 2022 223 664

## Description

### CROSS-REFERENCE TO RELATED APPLICATION

The present application claims priority to Korean patent application number 10-2022-0105701 filed on August 23, 2022.

### BACKGROUND

### 1. Field

Various embodiments of the present disclosure relate to a display device and a method of fabricating the display device.

### 2. Description of Related Art

Recently, as interest in information display increases, research and development on display devices have been continuously conducted.
US 2022/0223664 A1 discloses a display device.

### SUMMARY

Various embodiments of the present disclosure are directed to a display device having improved reliability.

Furthermore, various embodiments of the present disclosure are directed to a method of fabricating the display device.

One or more embodiments of the present invention provide a display device as recited in claim 1.

In one or more embodiments of the invention, the second step difference compensation pattern includes the same material as the color filter layer.

In one or more embodiments of the invention, each of the color filter layer and the second step difference compensation pattern includes a first color filter pattern, a second color filter pattern, and a third color filter pattern that are successively stacked. The first color filter pattern is a red color filter. The second color filter pattern is a green color filter. The third color filter pattern is a blue color filter.

In one or more embodiments, the first step difference compensation pattern may include a third end adjacent to the display area, and a fourth end opposite to the third end. The first end of the second step difference compensation pattern may be located closer to the display area than the third end of the first step difference compensation pattern is. The second end of the second step difference compensation pattern may be located closer to the edge of the substrate than is the fourth end of the first step difference compensation pattern, and covers the fourth end.

In one or more embodiments, the non-display area may include a first area closest to the display area, a second area adjacent to the first area, and a third area adjacent to the second area and the edge of the substrate. A dummy pixel may be located in the first area. Signal lines may be in the second area. An antistatic circuit may be located in the third area.

In one or more embodiments, the first step difference compensation pattern may be located in the second area.

In one or more embodiments, the second step difference compensation pattern may extend from the second area to the third area.

In one or more embodiments, the pixel may include: an emission area and a non-emission area; a transistor and a via layer on the substrate, the transistor being electrically connected to the light emitting element and the via layer covering the transistor; a bank pattern on the via layer and corresponding to at least the emission area; a first alignment electrode and a second alignment electrode located on the bank pattern, and spaced from each other; a first insulating layer on the first and the second alignment electrodes; a first bank located in the non-emission area, and including an opening corresponding to the emission area; the light emitting element located in at least the emission area, and on the first insulating layer between the first alignment electrode and the second alignment electrode; a second insulating layer located on the light emitting element and exposing the first end and the second end of the light emitting element; a first electrode and a second electrode located in at least the emission area, and spaced from each other on the insulating layer; a third insulating layer on the first and the second electrodes and the first bank; the color conversion layer located on the third insulating layer and located in the emission area to correspond to the light emitting element, and including color conversion particles; and a second bank on the first bank in the non-emission area, and around the color conversion layer.

In one or more embodiments, the first step difference compensation pattern may include the same material as the second bank.

In one or more embodiments, the bank pattern and the first bank may be in the display area, the first area, and the second area. The first and the third insulating layers may be located from the display area to the first area, the second area, and the third area. The first bank may be located over the bank pattern with the first insulating layer interposed therebetween, and overlaps the bank pattern.

In one or more embodiments, the first insulating layer may include a first opening exposing one area of the bank pattern. The third insulating layer may include a second opening exposing one area of the first bank.

In one or more embodiments, the via layer may include, in the third area, a valley formed by removing a portion of the via layer. The first insulating layer may be over the valley and covers the valley. The third insulating layer may be on the first insulating layer.

In one or more embodiments, the fourth end of the first step difference compensation pattern may be located in the third area, and cover, in the second area, the first bank located closest to the third area.

In one or more embodiments, the via layer may include, in the second area, a valley formed by removing a portion of the via layer. The first insulating layer may be over the valley and covers the valley. The third insulating layer may be on the first insulating layer. The first step difference compensation pattern may overlap the valley.

In one or more embodiments, the fourth end of the first step difference compensation pattern may be located, in the second area, on the third insulating layer on the first bank located closest to the third area, and overlaps the first bank.

In one or more embodiments, the second step difference compensation pattern may include a black matrix.

In one or more embodiments, the display device may further include: a first capping layer on the second bank and the color conversion layer; a low refractive layer on the first capping layer; a second capping layer on the low refractive layer; a planarization layer on the color filter layer; and an overcoat layer disposed on the planarization layer. The first capping layer, the second capping layer, and the planarization layer may be disposed in the display area, the first area, the second area, and the third area. The low refractive layer and the overcoat layer may be in the display area, the first area, and the second area.

In one or more embodiments, an end of the low refractive layer may be located on one surface of the first capping layer on the first step difference compensation pattern in the second area. An end of the overcoat layer may be located on one surface of the planarization layer on the second step difference compensation pattern in the second area.

In one or more embodiments, the display device may further include an antireflection film on the overcoat layer and the planarization layer and coupled to the substrate.

One or more embodiments of the present invention provide a method of fabricating a display device as recited in claim 13.

### BRIEF DESCRIPTION OF THE DRAWINGS

FIG. 1 is a schematic perspective view illustrating a light emitting element.
FIG. 2 is a schematic cross-sectional view illustrating the light emitting element of FIG. 1.
FIG. 3 is a schematic plan view illustrating a display device.
FIG. 4 is a schematic cross-sectional view illustrating a display panel of FIG. 3.
FIG. 5 is a schematic circuit diagram illustrating an electrical connection relationship of components included in each of the pixels illustrated in FIG. 3.
FIG. 6 is a schematic plan view illustrating a display element layer of a pixel.
FIGS. 7 to 9 are schematic cross-sectional views taken along the line II-II' of FIG. 6.
FIG. 10 is a schematic cross-sectional view taken along the line III-III' of FIG. 6.
FIGS. 11 to 16 are schematic cross-sectional views taken along the line I-I' of FIG. 3.
FIGS. 17 to 27 are views for describing a method of fabricating a display device, and are schematic cross-sectional views corresponding to the line I-I' of FIG. 3.

### DETAILED DESCRIPTION

As the present disclosure allows for various changes and numerous embodiments, particular embodiments will be illustrated in the drawings and described in detail in the written description. However, this is not intended to limit the present disclosure to particular modes of practice.

Throughout the present disclosure, like reference numerals refer to like parts throughout the various figures and embodiments of the present disclosure. The sizes of elements in the accompanying drawings may be exaggerated for clarity of illustration. It will be understood that, although the terms "first", "second", etc. may be used herein to describe various elements, these elements should not be limited by these terms. These terms are only used to distinguish one element from another element. For instance, a first element discussed below could be termed a second element without departing from the teachings of the present disclosure. Similarly, the second element could also be termed the first element.

It will be further understood that the terms "comprise", "include", "have", etc. when used in this specification, specify the presence of stated features, integers, steps, operations, elements, components, and/or combinations of them but do not preclude the presence or addition of one or more other features, integers, steps, operations, elements, components, and/or combinations thereof. Furthermore, in case that a first part such as a layer, a film, a region, or a plate is disposed on a second part, the first part may be not only directly on the second part but a third part may intervene between them. In addition, in case that it is expressed that a first part such as a layer, a film, a region, or a plate is formed on a second part, the surface of the second part on which the first part is formed is not limited to an upper surface of the second part but may include other surfaces such as a side surface or a lower surface of the second part. To the contrary, in case that a first part such as a layer, a film, a region, or a plate is under a second part, the first part may be not only directly under the second part but a third part may intervene between them.

It will be understood that when an element (e.g., a first element) is referred to as being (operatively or communicatively) "coupled with/to," or "connected with/to" another element (e.g., a second element), the first element can be coupled or connected with/to the second element directly or via another element (e.g., a third element). In contrast, it will be understood that when an element (e.g., a first element) is referred to as being "directly coupled with/to" or "directly connected with/to" another element (e.g., a second element), no other element (e.g., a third element) intervenes between the element and the other element.

Embodiments and required details of the present disclosure are described with reference to the accompanying drawings in order to describe the present disclosure in detail so that those having ordinary knowledge in the technical field to which the present disclosure pertains can easily practice the present disclosure. Furthermore, a singular form may include a plural form as long as it is not specifically mentioned in a sentence.

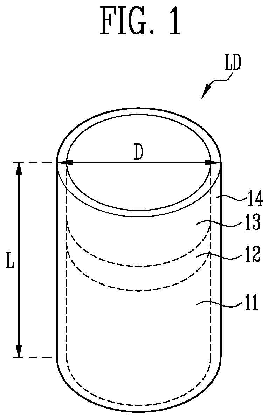

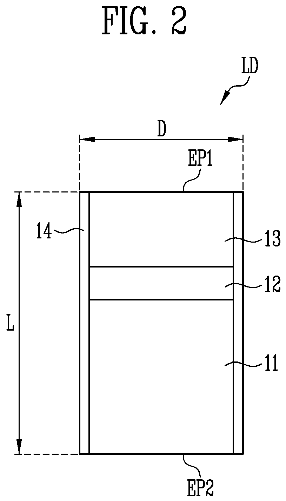

FIG. 1 is a schematic perspective view illustrating a light emitting element LD. FIG. 2 is a schematic cross-sectional view illustrating the light emitting element LD of FIG. 1.

Referring to FIGS. 1 and 2, the light emitting element LD may include a first semiconductor layer 11, a second semiconductor layer 13, and an active layer 12 interposed between the first and second semiconductor layers 11 and 13. For example, the light emitting element LD may be implemented as an emission stack (or referred to as "stack pattern") formed by successively stacking the first semiconductor layer 11, the active layer 12, and the second semiconductor layer 13. The type and/or shape of the light emitting element LD is not limited to that illustrated in FIG. 1.

The light emitting element LD may be formed in a shape extending in one direction. If the direction in which the light emitting element LD extends is defined as a longitudinal direction, the light emitting element LD may have a first end EP1 and a second end EP2 that are opposite to each other with respect to the longitudinal direction. One semiconductor layer of the first semiconductor layer 11 and the second semiconductor layer 13 may be disposed on the first end EP1 of the light emitting element LD, and the other semiconductor layer of the first semiconductor layer 11 and the second semiconductor layer 13 may be disposed on the second end EP2 of the light emitting element LD. For example, the second semiconductor layer 13 may be disposed on the first end EP1 of the light emitting element LD, and the first semiconductor layer 11 may be disposed on the second end EP2 of the light emitting element LD.

The light emitting element LD may be provided in various shapes. For example, as illustrated in FIG. 1, the light emitting element LD may have a rod-like shape, a bar-like shape, or a pillar-like shape which is long with respect to the longitudinal direction (i.e., to have an aspect ratio greater than 1). Alternatively, the light emitting element LD may have a rod-like shape, a bar-like shape, or a pillar-like shape which is short with respect to the longitudinal direction (or has an aspect ratio less than 1). As a further alternative, the light emitting element LD may have a rod-like shape, a bar-like shape, or a pillar-like shape having an aspect ratio of 1.

The light emitting element LD may include a light emitting diode (LED) fabricated to have a subminiature size, e.g., with a diameter D and/or a length L corresponding to a range from the nano scale (or the nanometer scale) to the micro scale (or the micrometer scale).

In case that the light emitting element LD is long (i.e., to have an aspect ratio greater than 1) with respect to the longitudinal direction, the diameter D of the light emitting element LD may approximately range from 0.5 µm to 6 µm, and the length L thereof may approximately range from 1 µm to 10 µm. However, the diameter D and the length L of the light emitting element LD are not limited thereto. The size of the light emitting element LD may be changed to meet requirements (or design conditions) of a lighting device or a self-emissive display device to which the light emitting element LD is applied.

The first semiconductor layer 11 may include, for example, at least one n-type semiconductor layer. For instance, the first semiconductor layer 11 may include an n-type semiconductor layer that includes any one semiconductor material selected from among InAlGaN, GaN, AlGaN, InGaN, AlN, and InN and is doped with a first conductive dopant (or an n-type dopant) such as Si, Ge, or Sn. However, the constituent material of the first semiconductor layer 11 is not limited to thereto, and various other materials may be used to form the first conductive semiconductor layer 11.

The active layer 12 may be disposed on the first semiconductor layer 11 and have a single- or multi-quantum well structure. For example, in case that the active layer 12 has a multi-quantum well structure, the active layer 12 may be formed by periodically repeatedly stacking a barrier layer, a strain reinforcing layer, and a well layer that are provided as one unit. The strain reinforcing layer may have a lattice constant less than that of the barrier layer so that resistance to strain, e.g., compressive strain, to be applied to the well layer can be further reinforced. However, the structure of the active layer 12 is not limited to that of the foregoing.

The active layer 12 may emit light having a wavelength ranging from 400 nm to 900 nm, and have a double hetero structure. A clad layer doped with a conductive dopant may be formed over and/or under the active layer 12 with respect to the longitudinal direction of the light emitting element LD. For example, the clad layer may be formed of an AlGaN layer or an InAlGaN layer. Material such as AlGaN or InAlGaN may be used to form the active layer 12, and various other materials may be used to form the active layer 12. The active layer 12 may include a first surface that contacts the first semiconductor layer 11, and a second surface that contacts the second semiconductor layer 13.

If an electric field having a certain voltage or more is applied between the opposite ends of the light emitting element LD, the light emitting element LD may emit light by coupling of electron-hole pairs in the active layer 12. Because light emission of the light emitting element LD can be controlled based on the foregoing principle, the light emitting element LD may be used as a light source (a light emitting source) of various light emitting devices as well as a pixel of a display device.

The second semiconductor layer 13 may be disposed on the second surface of the active layer 12 and include a semiconductor layer of a type different from that of the first semiconductor layer 11. For example, the second semiconductor layer 13 may include at least one p-type semiconductor layer. For instance, the second semiconductor layer 13 may include a p-type semiconductor layer that includes any one semiconductor material selected from among InAlGaN, GaN, AlGaN, InGaN, AlN, and InN, and is doped with a second conductive dopant (or a p-type dopant) such as Mg, Zn, Ca, Sr, or Ba. However, the material for forming the second semiconductor layer 13 is not limited thereto, and various other materials may be used to form the second semiconductor layer 13.

The first semiconductor layer 11 and the second semiconductor layer 13 may have different thicknesses with respect to the longitudinal direction of the light emitting element LD. For example, the first semiconductor layer 11 may have a thickness greater than that of the second semiconductor layer 13 with respect to the longitudinal direction of the light emitting element LD. Hence, the active layer 12 of the light emitting element LD may be disposed at a position closer to the upper surface of the second semiconductor layer 13 than to the lower surface of the first semiconductor layer 11.

Although FIGS. 1 and 2 illustrate that the first semiconductor layer 11 and the second semiconductor layer 13 each is formed of a single layer, the present disclosure is not limited thereto. Depending on the material of the active layer 12, the first semiconductor layer 11 and the second semiconductor layer 13 each may further include one or more layers, for example, a clad layer and/or a tensile strain barrier reducing (TSBR) layer. The TSBR layer may be a strain relief layer that is disposed between semiconductor layers having different lattice structures and thus can function as a buffer layer to reduce a difference in lattice constant. Although the TSBR layer may be formed of a p-type semiconductor layer such as p-GaInP, p-AlInP, or p-AlGaInP, the present disclosure is not limited thereto.

The light emitting element LD may further include a contact electrode (hereinafter referred to as "first contact electrode") disposed over the second semiconductor layer 13, as well as including the first semiconductor layer 11, the active layer 12, and the second semiconductor layer 13. Furthermore, the light emitting element LD may further include an additional contact electrode (hereinafter referred to as "second contact electrode") disposed on one end of the first semiconductor layer 11.

Each of the first and second contact electrodes may be an ohmic contact electrode, but the present disclosure is not limited thereto. Each of the first and second contact electrodes may be a Schottky contact electrode. The first and second contact electrodes may include conductive material. For example, the first and second contact electrodes may include opaque metal such as chrome (Cr), titanium (Ti), aluminum (Al), gold (Au), nickel (Ni), and oxides or alloys thereof, which are used alone or in combination, but the present disclosure is not limited thereto. The first and second contact electrodes may also include transparent conductive oxides such as indium tin oxide (ITO), indium zinc oxide (IZO), zinc oxide (ZnOₓ), indium gallium zinc oxide (IGZO), and indium tin zinc oxide (ITZO). Here, the zinc oxide (ZnOₓ) may be zinc oxide (ZnO) and/or zinc peroxide (ZnO₂).

Materials included in the first and second contact electrodes may be equal to or different from each other. The first and second contact electrodes may be substantially transparent or translucent. Therefore, light generated from the light emitting element LD may pass through each of the first and second contact electrodes and then may be emitted out of the light emitting element LD. In case that light generated from the light emitting element LD is emitted out of the light emitting element LD through an area other than the opposite ends of the light emitting element LD rather than passing through the first and second contact electrodes, the first and second contact electrodes may include opaque metal.

The light emitting element LD may further include an insulating film 14. However, the insulating film 14 may be omitted, or may be provided to cover only some of the first semiconductor layer 11, the active layer 12, and the second semiconductor layer 13.

The insulating film 14 may prevent the active layer 12 from short-circuiting due to making contact with conductive material except the first and second semiconductor layers 11 and 13. Furthermore, the insulating film 14 may reduce or minimize a surface defect of the light emitting element LD, thus enhancing the lifetime and emission efficiency of the light emitting element LD. In case that a plurality of light emitting elements LD are disposed in close contact with each other, the insulating film 14 may prevent an undesired short-circuit from occurring between the light emitting elements LD. The presence or non-presence of the insulating film 14 is not limited, so long as the active layer 12 can be prevented from short-circuiting with external conductive material.

The insulating film 14 may be provided to be around (e.g., to enclose) an outer surface (e.g., an overall outer peripheral or circumferential surface) of the emission stack including the first semiconductor layer 11, the active layer 12, and the second semiconductor layer 13.

Although in the foregoing, the insulating film 14 has been described as enclosing the entirety of the respective outer surfaces (e.g., outer peripheral or circumferential surfaces) of the first semiconductor layer 11, the active layer 12, and the second semiconductor layer 13, the present disclosure is not limited thereto. In the case that the light emitting element LD includes the first contact electrode, the insulating film 14 may enclose the entirety of the respective outer surfaces (e.g., outer peripheral or circumferential surfaces) of the first semiconductor layer 11, the active layer 12, the second semiconductor layer 13, and the first contact electrode. The insulating film 14 may not enclose the entirety of the outer surface (e.g., the outer peripheral or circumferential surface) of the first semiconductor layer 11, or may enclose only a portion of the outer surface (e.g., the outer peripheral or circumferential surface) of the first semiconductor layer 11 without enclosing the other portion of the outer surface (e.g., the outer peripheral or circumferential surface) of the first semiconductor layer 11. Furthermore, in the case that the first contact electrode is disposed on the first end EP1 of the light emitting element LD and the second contact electrode is disposed on the second end EP2 of the light emitting element LD, the insulating film 14 may allow at least one area of each of the first and second contact electrodes to be exposed.

The insulating film 14 may include transparent insulating material. For example, the insulating film 14 may be include one or more insulating materials selected from the group constituting of silicon oxide (SiOₓ), silicon nitride (SiNₓ), silicon oxynitride (SiOₓN_{y}), aluminum oxide (AlOₓ), titanium oxide (TiOₓ), hafnium oxide (HfOₓ), titanstrontium oxide (SrTiOₓ), cobalt oxide (CoₓO_{y}), magnesium oxide (MgO), zinc oxide (ZnOₓ), ruthenium Oxide (RuOₓ), nickel oxide (NiO), tungsten oxide (WOₓ), tantalum oxide (TaOₓ), gadolinium oxide (GdOₓ), zirconium oxide (ZrOₓ), gallium oxide (GaOₓ), vanadium oxide (VₓO_{y}), ZnO:Al, ZnO:B, InxOy:H, niobium oxide (NbₓO_{y}), magnesium fluoride (MgFₓ), aluminum fluoride (AlFₓ), an alucone polymer film, titanium nitride (TiN), tantalum nitride (TaN), aluminum nitride (AlNₓ), gallium nitride (GaN), tungsten nitride (WN), hafnium nitride (HfN), niobium nitride (NbN), gadolinium nitride (GdN), zirconium nitride (ZrN), and vanadium nitride (VN). However, the present disclosure is not limited thereto, and various materials having insulation may be used as the material of the insulating film 14.

The insulating film 14 may have a single-layer structure or a multi-layer structure including a double-layer structure. For example, in case that the insulating film 14 is formed of a double-layer structure including a first layer and a second layer that are successively stacked, the first layer and the second layer may be made of different materials (or substances) and may be formed through different processes. The first layer and the second layer may include the same material and may be formed through a successive process.

The light emitting element LD may be implemented as a light emitting pattern having a core-shell structure. In this case, the first semiconductor layer 11 may be disposed in a core of the light emitting element LD, i.e., a central portion of the light emitting element LD. The active layer 12 may be provided and/or formed to be around (e.g., to enclose) the outer surface (e.g., the outer peripheral or circumferential surface) of the first semiconductor layer 11. The second semiconductor layer 13 may be provided and/or formed to be around (e.g., to enclose) the active layer 12. Furthermore, the light emitting element LD may further include a contact electrode located at or adjacent to least one side of the second semiconductor layer 13. The light emitting element LD may further include an insulating film 14 that is provided on the outer surface (e.g., the outer peripheral or circumferential surface) of the light emitting pattern having a core-shell structure and has transparent insulating material. The light emitting element LD implemented as the light emitting pattern having the core-shell structure may be manufactured in a growth manner.

The light emitting element LD may be employed as a light emitting source (or a light source) for various display devices. The light emitting element LD may be fabricated through a surface treatment process. For example, the light emitting element LD may be surface-treated so that, when a plurality of light emitting elements LD are mixed with a fluidic solution (or solvent) and then supplied to each pixel area (e.g., an emission area of each pixel or an emission area of each sub-pixel), the light emitting elements LD can be evenly distributed rather than unevenly aggregating in the solution.

An emission component (or a light emitting device or a light emitting unit) including the light emitting element LD described above may be used not only in a display device but also in various types of electronic devices each of which requires a light source. For instance, in case that a plurality of light emitting elements LD are disposed in the pixel area of each pixel of a display panel, the light emitting elements LD may be used as a light source of the pixel. However, the application field of the light emitting element LD is not limited to the above-mentioned examples. For example, the light emitting element LD may also be used in other types of electronic devices such as a lighting device, which requires a light source.

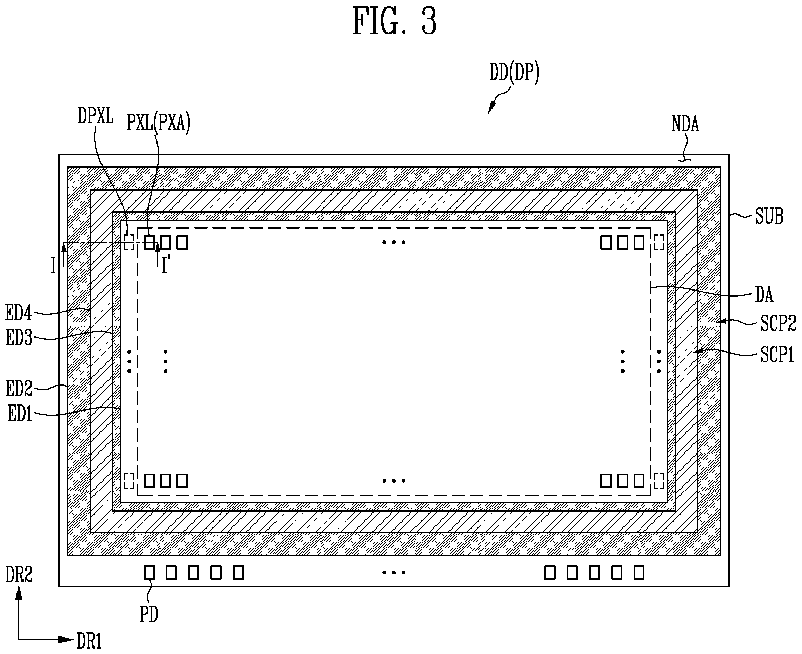

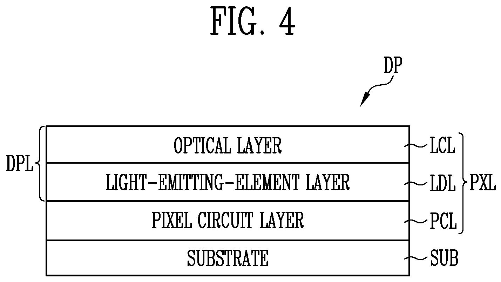

FIG. 3 is a schematic plan view illustrating a display device DD. FIG. 4 is a schematic cross-sectional view illustrating a display panel DP of FIG. 3.

In FIGS. 3 and 4, for the convenience sake, there is schematically illustrated the display device DD, particularly, the structure of a display panel DP provided in the display device DD, centered on a display area DA in which an image is displayed.

If the display device DD is an electronic device having a display surface on at least one surface thereof, e.g., a smartphone, a television, a tablet PC, a mobile phone, a video phone, an electronic reader, a desktop PC, a laptop PC, a netbook computer, a workstation, a server, a PDA, a portable multimedia player (PMP), an MP3 player, a medical appliance, a camera, or a wearable device, the present disclosure may be applied to the display device DD.

Referring to FIGS. 1 to 4, the display device DD may be classified into a passive matrix type display device and an active matrix type display device according to a method of driving the light emitting element LD. For example, in case that the display device DD is implemented as an active matrix type, each of the pixels PXL may include a driving transistor configured to control the amount of current to be supplied to the light emitting element LD, and a switching transistor configured to transmit data signals to the driving transistor.

The display panel DP (or the display device DD) may include a substrate SUB, and pixels PXL disposed on the substrate SUB. Each pixel PXL may include at least one light emitting element LD.

The substrate SUB may include transparent insulating material to allow light transmission. The substrate SUB may be a rigid substrate or a flexible substrate.

For example, the rigid substrate SUB may be one of a glass substrate, a quartz substrate, a glass ceramic substrate, and a crystalline glass substrate.

The flexible substrate SUB may be either a film substrate or a plastic substrate that includes polymer organic material. For example, the flexible substrate SUB may include at least one selected from among the following: polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, or cellulose acetate propionate.

One area on the substrate SUB may be provided as the display area DA in which the pixels PXL are disposed, and the other area on the substrate SUB may be provided as the non-display area NDA. For example, the substrate SUB may include the display area DA including a plurality of pixel areas PXA on which the respective pixels PXL are disposed, and the non-display area NDA disposed around an edge or perimeter of the display area DA (or adjacent to the display area DA).

The pixels PXL may be provided in the display area DA on the substrate SUB. The pixels PXL may be arranged in the display area DA in a stripe or PENTILE^{®} arrangement structure, or the like, but the present disclosure is not limited thereto. The PENTILE^{®} pixel arrangement structure may be referred to as an RGBG matrix structure (e.g., a PENTILE^{®} matrix structure or an RGBG structure (e.g., a PENTILE^{®} structure)). PENTILE^{®} is a registered trademark of Samsung Display Co., Ltd., Republic of Korea.

Each pixel PXL may include a pixel circuit layer PCL and a display element layer DPL including a light-emitting element layer LDL and an optical layer LCL that are disposed on the substrate SUB.

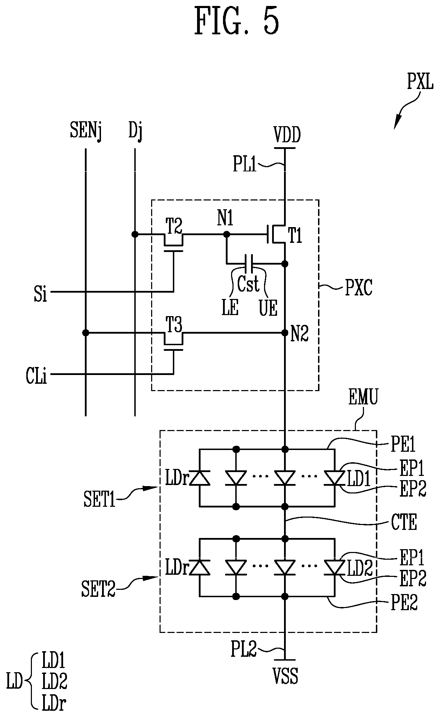

A pixel circuit (refer to "PXC" of FIG. 5) that is provided on the substrate SUB and includes a plurality of transistors and signal lines electrically connected to the transistors may be disposed in the pixel circuit layer PCL. Each transistor has a structure in which, for example, a semiconductor layer, a gate electrode, a first terminal, and a second terminal are successively stacked with insulating layers interposed therebetween. The semiconductor layer may include amorphous silicon, poly silicon, low temperature poly silicon, and an organic semiconductor, and/or an oxide semiconductor. Although the gate electrode, the first terminal (or the source electrode), and the second terminal (or the drain electrode) each may include one of aluminum (Al), copper (Cu), titanium (Ti), and molybdenum (Mo), the present disclosure is not limited thereto. In addition, the pixel circuit layer PCL may include at least one or more insulating layers.

The display element layer DPL may be disposed on the pixel circuit layer PCL. The display element layer DPL may include the light-emitting-element layer LDL and the optical layer LCL.

The light-emitting-element layer LDL may be disposed on the pixel circuit layer PCL. An emission component (refer to "EMU" of FIG. 5) including a light emitting element LD configured to emit light may be disposed in the light-emitting-element layer LDL. A first alignment electrode (or a first alignment line) and a second alignment electrode (or a second alignment line) that are spaced from each other may be disposed in the emission component EMU. The light emitting element LD may be disposed between the first alignment electrode and the second alignment electrode.

The optical layer LCL may be disposed on the light-emitting-element layer LDL. The optical layer LCL may convert light emitted from the light emitting element LD to light having excellent color reproducibility and emit the converted light, thus enhancing the light output efficiency of each pixel PXL. The optical layer LCL may include a color conversion layer and a color filter layer.

Each pixel PXL may include at least one or more light emitting elements LD configured to be driven in response to a corresponding scan signal and a corresponding data signal. The light emitting element LD may have a small size ranging from the nano scale (or the nanometer scale) to the micro scale (the mircrometer scale) and may be connected in parallel to light emitting elements LD disposed adjacent thereto, but the present disclosure is not limited thereto. The light emitting element LD may form a light source of each pixel PXL.

The non-display area NDA may be disposed adjacent to the display area DA. The non-display area NDA is provided on at least one side of the display area DA. For example, the non-display area NDA may enclose the perimeter (or edges) of the display area DA. A line component connected to each of the pixels PXL, and a driver connected to the line component and configured to drive the pixel PXL may be provided in the non-display area NDA.

The non-display area NDA may be an area in which suitable lines (e.g., predetermined lines, e.g., fanout lines), pads PD, dummy pixels DPXL, and/or an internal circuit that are electrically connected with the pixels PXL to drive the pixels PXL are provided.

The pads PD may supply (or transmit) driving power voltages and signals for driving the pixels PXL provided in the display area DA and/or the internal circuits.

The dummy pixels DPXL may have a structure equal or substantially similar to that of the pixels PXL provided in the display area DA. The dummy pixels DPXL may be located in one area of the non-display area NDA and may be electrically separated from the pixels PXL. The dummy pixels DPXL may be provided in an isolated shape in one area of the non-display area NDA. The dummy pixels DPXL may be provided in the non-display area NDA so as to prevent a defect attributable to a deviation from being caused during a fabricating process, and may be selectively provided depending on the implementation.

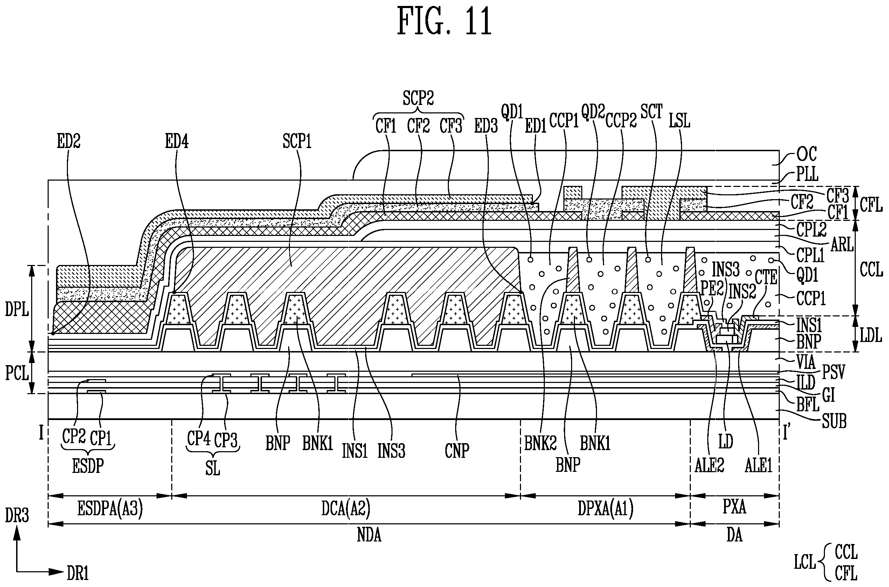

A step difference compensation pattern is disposed in the non-display area NDA. The step difference compensation pattern may mitigate a step difference formed by components located in the non-display area NDA, and may control, during a process of forming a low refractive layer (refer to "ARL" of FIG. 11) and an overcoat layer (refer to "OC" of FIG. 11) disposed in the display area DA, a flow rate of a base material (e.g., an inkjet type material) of the low refractive layer and a base material (e.g., an inkjet type material) of the overcoat layer, thus preventing the base materials from moving into an undesired area.

The step difference compensation pattern may include a first step difference compensation pattern SCP1 and a second step difference compensation pattern SCP2 (e.g., see FIG. 11).

Both the first step difference compensation pattern SCP1 and the second step difference compensation pattern SCP2 are located in the non-display area NDA. The second step difference compensation pattern SCP2 may be located closer to the display area DA than the first step difference compensation pattern SCP1 is (e.g., see FIG. 11). The present disclosure is not limited thereto. The first step difference compensation pattern SCP1 may be located closer to the display area DA than the second step difference compensation pattern SCP2 is.

The first step difference compensation pattern SCP1 is disposed to be around (e.g., to enclose or surround) the display area DA in a plan view. The second step difference compensation pattern SCP2 may be disposed to be around (e.g., to enclose) the display area DA, and may overlap the first step difference compensation pattern SCP1. The second step difference compensation pattern SCP2 includes a first end ED1 located adjacent to the display area DA, and a second end ED2 which is opposite the first end ED1 and is located adjacent to the edge of the substrate SUB. The first step difference compensation pattern SCP1 may be located between the first end ED1 and the second end ED2 of the second step difference compensation pattern SCP2, and may include a third end ED3 located adjacent to the display area DA, and a fourth end ED4 which is opposite the third end ED3 and is located closer to the edge of the substrate SUB than the third end ED3 is. The first and second step difference compensation patterns SCP1 and SCP2 may be located at or adjacent to at least one side of the dummy pixels DPXL (e.g. around the dummy pixel DPXL) in the non-display area NDA, but the present disclosure is not limited thereto.

Detailed description of the first and second step difference compensation patterns SCP1 and SCP2 will be made below with reference to FIG. 11.

FIG. 5 is a schematic circuit diagram illustrating an electrical connection relationship of components included in each of the pixels PXL illustrated in FIG. 3.

For example, FIG. 5 illustrates the electrical connection relationship of components included in the pixel PXL that may be employed in an active matrix type display device. Here, the connection relationship of the components of each pixel PXL is not limited thereto.

Referring to FIGS. 1 to 5, the pixel PXL may include an emission component EMU configured to generate light having a luminance corresponding to a data signal. Furthermore, the pixel PXL may optionally further include a pixel circuit PXC configured to drive the emission component EMU.

For example, the emission component EMU may include a first electrode PE1 (or a first pixel electrode) connected to a first driving power supply VDD by the pixel circuit PXC and a first power line PL1, a second electrode PE2 (or a second pixel electrode) connected to a second driving power supply VSS by a second power line PL2, and a plurality of light emitting elements LD that are electrically connected between the first and second electrodes PE1 and PE2. The first driving power supply VDD and the second driving power supply VSS may have different potentials to allow the light emitting elements LD to emit light. For example, the first driving power supply VDD may be set as a high-potential power supply, and the second driving power supply VSS may be set as a low-potential power supply.

The emission component EMU may include at least one series set. Each series set may include a pair of electrodes (e.g., two electrodes), and at least one light emitting element LD connected in a forward direction between the pair of electrodes. Here, the number of series sets that form the emission component EMU and the number of light emitting elements LD that form each series set are not particularly limited. For example, the numbers of light emitting elements LD that form the respective series sets may be similar (or identical) to or different from each other. The number of light emitting elements LD of each series set is not particularly limited.

For example, the emission circuit EMU may include a first series set SET1 including at least one first light emitting element LD1, and a second series set SET2 including at least one second light emitting element LD2.

The first series set SET1 may include a first electrode PE1, an intermediate electrode CTE (or a bridge electrode), and at least one first light emitting element LD1 electrically connected between the first electrode PE1 and the intermediate electrode CTE. Each first light emitting element LD1 may be connected in the forward direction between the first electrode PE1 and the first intermediate electrode CTE. For example, the first end EP1 of the first light emitting elements LD1 may be electrically connected to the first electrode PE1. The second end EP2 of the first light emitting element LD1 may be electrically connected to the intermediate electrode CTE.

The second series set SET2 may include the intermediate electrode CTE, a second electrode PE2, and at least one second light emitting element LD2 electrically connected between the intermediate electrode CTE and the second electrode PE2. Each second light emitting element LD2 may be connected in the forward direction between the intermediate electrode CTE and the second electrode PE2. For example, the first end EP1 of the second light emitting element LD2 may be electrically connected to the intermediate electrode CTE. The second end EP2 of the second light emitting element LD2 may be electrically connected to the second electrode PE2.

The 1st electrode of the emission component EMU, e.g., the first electrode PE1, may be an anode of the emission component EMU. The last electrode of the emission component EMU, e.g., the second electrode PE2, may be a cathode of the emission component EMU.

In case that the light emitting elements LD are connected to have a series/parallel structure, power efficiency may be enhanced, compared to the case where an equal number of light emitting elements LD are connected only in parallel to each other. Furthermore, in the pixel PXL in which the light emitting elements LD are connected to have a series/parallel structure, sufficient luminance can be expressed by the light emitting elements LD of some series stages, so that the probability of occurrence of a black spot defect in the pixel PXL can be reduced. However, the present disclosure is not limited thereto. The emission component EMU may be formed by connecting the light emitting elements LD only in series. Alternatively, the emission component EMU may be formed by connecting the light emitting elements LD only in parallel.

Each of the light emitting elements LD may include a first end EP1 (e.g., a p-type end) connected to the first driving power supply VDD via at least one electrode (e.g., the first electrode PE1), the pixel circuit PXC, the first power line PL1, and/or the like, and a second end EP2 (e.g., an n-type end) connected to the second driving power supply VSS via at least one additional electrode (e.g., the second electrode PE2), the second power line PL2, and the like. In other words, the light emitting elements LD may be connected in the forward direction between the first driving power supply VDD and the second driving power supply VSS. The light emitting elements LD connected in the forward direction may form valid light sources of the emission component EMU.

The emission component EMU may further include at least one invalid light source, e.g., a reverse light emitting element LDr, as well as including the light emitting elements LD that form the respective valid light sources.

The light emitting elements LD of the emission component EMU may emit light having a luminance corresponding to driving current supplied thereto through the pixel circuit PXC. For example, during each frame period, the pixel circuit PXC may supply driving current corresponding to a grayscale value of a corresponding frame data to the light emitting component EMU. The driving current supplied to the emission component EMU may be divided into parts that flow into the respective light emitting elements LD. Hence, each of the light emitting elements LD may emit light having a luminance corresponding to current applied thereto, so that the emission component EMU may emit light having a luminance corresponding to the driving current.

The pixel circuit PXC may be connected to a scan line Si and a data line Dj of the corresponding pixel PXL. For example, if the pixel PXL is disposed on an i-th row and a j-th column of the display area DA, the pixel circuit PXC of the pixel PXL may be connected to an i-th scan line Si and a j-th data line Dj of the display area DA. Furthermore, the pixel circuit PXC may be connected to an i-th control line CLi and a j-th sensing line SENj of the display area DA.

The pixel circuit PXC may include first to third transistors T1, T2, and T3, and a storage capacitor Cst.

The first transistor T1 may be a driving transistor configured to control driving current to be applied to the emission component EMU, and may be connected between the first driving power supply VDD and the emission component EMU. In detail, a first terminal of the first transistor T1 may be electrically connected to the first driving power supply VDD by the first power line PL1. A second terminal of the first transistor T1 may be electrically connected to a second node N2. A gate electrode of the first transistor T1 may be electrically connected to a first node N1. The first transistor T1 may control, in response to a voltage applied to the first node N1, the amount of driving current to be applied from the first driving power supply VDD to the emission component EMU through the second node N2. The first terminal of the first transistor T1 may be a drain electrode, and the second terminal of the first transistor T1 may be a source electrode, and the present disclosure is not limited thereto. The first terminal may be a source electrode, and the second terminal may be a drain electrode.

The second transistor T2 may be a switching transistor that selects a pixel PXL in response to a scan signal and activates the pixel PXL, and may be electrically connected between the data line Dj (e.g., the j-th data line) and the first node N1. A first terminal of the second transistor T2 may be electrically connected to the data line Dj. A second terminal of the second transistor T2 may be electrically connected to the first node N1. A gate electrode of the second transistor T2 may be electrically connected to the scan line Si (e.g., the i-th scan line). The first terminal and the second terminal of the second transistor T2 are different terminals, and, for example, if the first terminal is a drain electrode, and the second terminal may be a source electrode.

When a scan signal having a gate-on voltage (e.g., a high level voltage) is supplied from the scan line Si, the second transistor T2 may be turned on to electrically connect the data line Dj with the first node N1. The first node N1 may be a point at which the second terminal of the second transistor T2 and the gate electrode of the first transistor T1 are connected to each other. The second transistor T2 may transmit a data signal to the gate electrode of the first transistor T1.

The third transistor T3 may obtain a sensing signal through the sensing line SENj by connecting the first transistor T1 to the sensing line SENj (e.g., the j-th sensing line), and detect, using the sensing signal, characteristics of the pixel PXL such as a threshold voltage of the first transistor T1. Information about the characteristics of the pixel PXL may be used to convert image data such that a deviation in characteristic between pixels PXL can be compensated for. A second terminal of the third transistor T3 may be electrically connected to the second terminal of the first transistor T1. A first terminal of the third transistor T3 may be electrically connected to the sensing line SENj. A gate electrode of the third transistor T3 may be electrically connected to the control line CLi (e.g., the i-th control line). Furthermore, the first terminal of the third transistor T3 may be electrically connected to an initialization power supply. The third transistor T3 may be an initialization transistor configured to initialize the second node N2, and may be turned on when a sensing control signal is supplied thereto from the control line CLi, so that the voltage of the initialization power supply can be transmitted to the second node N2. Hence, an upper electrode UE (or a second storage electrode) of the storage capacitor Cst that is electrically connected to the second node N2 may be initialized.

The storage capacitor Cst may include a lower electrode LE (or a first storage electrode) and the upper electrode UE (or the second storage electrode). The lower electrode LE may be electrically connected to the first node N1. The upper electrode UE may be electrically connected to the second node N2. The storage capacitor Cst may be charged with a data voltage corresponding to a data signal to be supplied to the first node N1 during one frame period. Hence, the storage capacitor Cst may store a voltage corresponding to a difference between a voltage of the gate electrode of the first transistor T1 and a voltage of the second node N2.

Although FIG. 5 illustrates an implementation where all of the first to third transistors T1, T2, and T3 are N-type transistors, the present disclosure is not limited thereto. For example, at least one of the first transistor T1, the second transistor T2, or the third transistor T3 may be changed to a P-type transistor. Furthermore, although FIG. 5 illustrates an implementation where the emission component EMU is connected between the pixel circuit PXC and the second driving power supply VSS, the emission component EMU may be connected between the first driving power supply VDD and the pixel circuit PXC.

The structure of the pixel circuit PXC may be changed in various ways. For example, the pixel circuit PXC may further include at least one transistor element such as a transistor element configured to initialize the first node N1, and/or a transistor element configured to control an emission time of the light emitting elements LD, or other circuit elements such as a boosting capacitor configured to boost the voltage of the first node N1.

For the sake of explanation, a transverse direction (or an X-axis direction) in a plan view will be indicated by a first direction DR1, a longitudinal direction (or an Y-axis direction) in a plan view will be indicated by a second direction DR2, and a vertical direction in a sectional will be indicated by a third direction DR3.

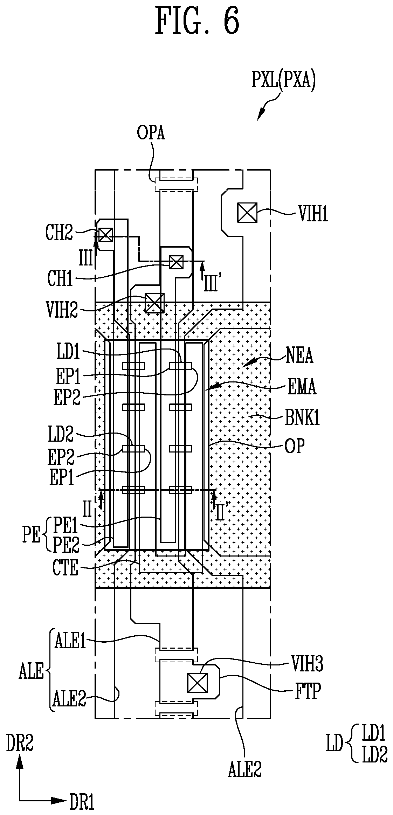

FIG. 6 is a schematic plan view illustrating the display element layer DPL of the pixel PXL.

In FIG. 6, for convenience of description, illustration of the transistors electrically connected to the light emitting elements LD and the signal lines electrically connected to the transistors is omitted.

In the following, not only the components included in the pixel PXL illustrated in FIG. 6 but also an area in which the components are provided (or located) may be embraced in the definition of the term "pixel PXL".

Referring to FIGS. 1 to 6, the pixel PXL may be disposed in a pixel area PXA provided (or defined) on the substrate SUB.

The pixel PXL may include a first bank BNK1 located in the non-emission area NEA, and light emitting elements LD located in the emission area EMA.

The first bank BNK1 may be a structure for defining (or partitioning) the respective pixel areas PXA (or the respective emission areas EMA) of the pixel PXL and pixels PXL adjacent thereto and, for example, may be a pixel defining layer.

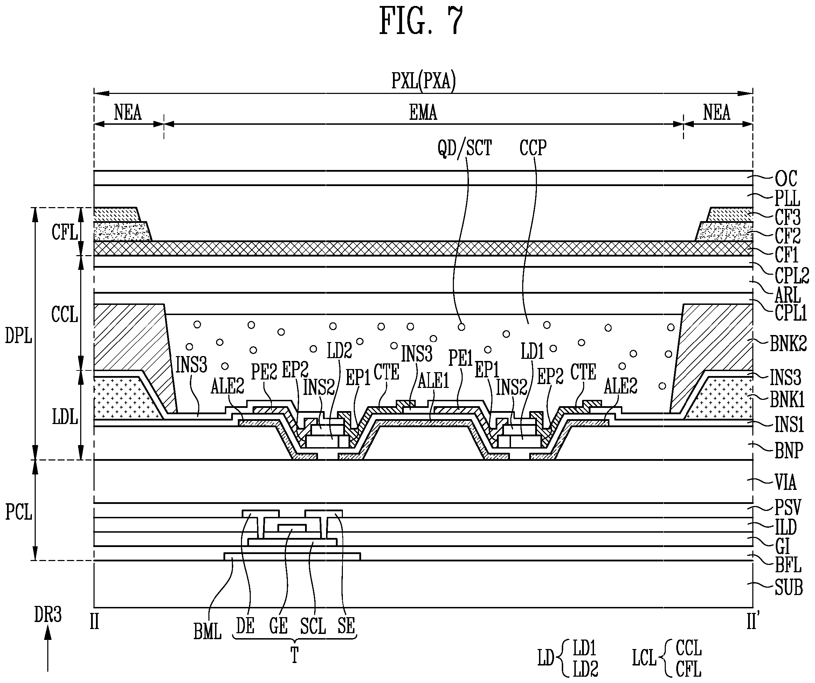

The first bank BNK1 may be a pixel defining layer or a dam structure for defining each emission area EMA to which the light emitting elements LD are to be supplied, during a process of supplying (or inputting) the light emitting elements LD to the pixel PXL. For example, because the emission area EMA of the pixel PXL is defined by the first bank BNK1, a mixed solution (e.g., ink) including a target amount and/or type of light emitting elements LD may be supplied (or input) to the emission area EMA. During a process of supplying a color conversion pattern (refer to "CCP" of FIG. 7) to the pixel PXL, the first bank BNK1 may be a pixel defining layer that ultimately defines each emission area EMA to which the color conversion pattern CCP is to be supplied.

The first bank BNK1 may include at least one light block material and/or reflective material (or scattering material), thus preventing a light leakage defect in which light leaks between the pixel PXL and the pixels PXL adj acent thereto. The first bank BNK1 may include transparent material (or substance). The transparent material may include, for example, polyamides resin, polyimides resin, and the like, but the present disclosure is not limited thereto. In order to enhance the efficiency of light emitted from the pixel PXL, a separate reflective material layer may be provided and/or formed on the first bank BNK1.

The first bank BNK1 may include, in the pixel area PXA, at least one opening OP that exposes components disposed thereunder. The emission area EMA of the pixel PXL and the opening OP of the first bank BNK1 may correspond to each other.

An electrode separation area OPA may be disposed in the non-emission area NEA of each pixel PXL. The electrode separation area OPA may be an area in which a first alignment electrode ALE1 in each pixel PXL is separated from a first alignment electrode ALE1 provided in a pixel PXL disposed adjacent thereto in the second direction DR2

The display element layer DPL (or the emission component EMU) may include an electrode PE (or a pixel electrode) provided in the emission area EMA, light emitting elements LD electrically connected to the electrode PE, and alignment electrodes ALE provided at a position corresponding to the electrode PE. For example, a first electrode PE1 (or a first pixel electrode), a second electrode PE2 (or a second pixel electrode), the light emitting elements LD, and first and second alignment electrodes ALE1 and ALE2 may be disposed in the emission area EMA. Furthermore, an intermediate electrode CTE may be disposed in the emission area EMA. The electrodes PE and/or the alignment electrodes ALE each may be changed in number, shape, size, arrangement structure, etc. in various ways depending on the structure of the pixel PXL (particularly, the emission component EMU).

Based on one surface of the substrate SUB on which the pixel PXL is provided, the alignment electrodes ALE, the light emitting elements LD, and the electrodes PE may be provided in the order listed, but the present disclosure is not limited thereto. The positions and formation sequence of electrode patterns that form the pixel PXL (or the emission component EMU) may be changed in various ways. Description of a stacked structure (or a cross-section structure) of the pixel PXL will be described below with reference to FIGS. 7 to 10.

The alignment electrodes ALE may be disposed in at least the emission area EMA, and be spaced from each other with respect to the first direction DR1 in the emission area EMA, and each may extend in the second direction DR2. The alignment electrodes ALE may include a second alignment electrode ALE2, a first alignment electrode ALE1, or an additional second alignment electrode ALE2 that are spaced from each other in the first direction DR1.

At least one of the second alignment electrode ALE2, the first alignment electrode ALE1, or the additional second alignment electrode ALE2 may be separated from other electrodes (e.g., an alignment electrode ALE provided in an adjacent pixel PXL adjacent to each pixel PXL in the second direction DR2) after the light emitting elements LD have been supplied to and aligned in the emission area EMA during a process of fabricating the display device DD. For example, the first alignment element ALE1 may be separated from first alignment electrodes ALE1 provided in adjacent pixels PXL adjacent to the corresponding pixel PXL after the light emitting elements LD have been supplied to and aligned in the emission area EMA during the process of fabricating the display device DD.

In detail, the first alignment electrodes ALE1 provided in the display area DA may be formed to be connected to each other during the process of fabricating the display device DD (or the pixel PXL). For example, the first alignment electrodes ALE1 may be integrally connected to a floating pattern FTP, thus forming the first alignment line. The floating pattern FTP may be electrically connected to a component of the pixel circuit layer PCL, for example, to the first power line (refer to "PL1" of FIG. 5), through a third via hole VIH3. During a process of aligning the light emitting elements LD, a first alignment signal may be supplied to the first alignment line through the first power line PL1. After the process of aligning the light emitting elements LD has been completed, a portion of the first alignment line around the third via hole VIH3 located in the non-emission area NEA may be removed (or the first alignment line may be cut off), whereby the electrical connection between the first alignment electrodes ALE1 and the first power line PL1 may be interrupted. For example, the first alignment line may be cut off in the electrode separation areas OPA located around the floating pattern FTP, so that the first alignment line may be divided into first alignment electrodes ALE1 and floating patterns FTP. Furthermore, the first alignment line may be cut off in the electrode separation area OPA between adjacent pixel columns, so that the first alignment electrodes ALE1 of adjacent pixels PXL can be separated from each other. Therefore, the first alignment electrodes ALE1 of the pixels PXL disposed on the same pixel column may be electrically separated from each other, whereby the pixels PXL may be individually driven.

In a plan view, the second alignment electrode ALE2, the first alignment electrode ALE1, and the additional second alignment electrode ALE2 may be arranged in the order listed with respect to the first direction DR1 in the emission area EMA. The second alignment electrode ALE2 may be disposed adjacent to one side (e.g., a left side) of the first alignment electrode ALE1, and the additional second alignment electrode ALE2 may be disposed adjacent to another side (e.g., a right side) of the first alignment electrode ALE1.

The first alignment electrode ALE1 may be electrically connected, through a second via hole VIH2, to a component of the pixel circuit PXC, e.g., to the upper electrode (refer to "UE" of FIG. 5, or the second storage electrode) of the storage capacitor (refer to "Cst" of FIG. 5). The second via hole VIH2 may be formed by opening one area of an insulating layer that is located between the first alignment electrode ALE1 and the upper electrode UE.

The second alignment electrode ALE2 may be electrically connected to a component of the pixel circuit layer PCL, e.g., to the second power line (refer to "PL2" of FIG. 5), through a first via hole VIH1. The first via hole VIH1 may be formed by opening one area of an insulating layer that is located between the additional second alignment electrode ALE2 and the second power line PL2.

In the emission area EMA, each of the second alignment electrode ALE2, the first alignment electrode ALE1, and the additional second alignment electrode ALE2 may be spaced from an alignment electrode ALE adjacent thereto in the first direction DR1. The second alignment electrodes ALE2 may be separately or integrally formed with and electrically connected to second alignment electrodes ALE2 disposed in an adjacent pixel PXL. For example, the second alignment electrode ALE2 may be electrically connected to an additional second alignment electrode ALE2 of an adjacent pixel PXL. The additional second alignment electrode ALE2 may be electrically connected to a second alignment electrode ALE2 of an adjacent pixel PXL.

The second alignment electrode ALE2, the first alignment electrode ALE1, and the additional second alignment electrode ALE2 each may be used as an alignment line provided for alignment of the light emitting elements LD and configured to receive a signal (e.g., an alignment signal) before the light emitting elements LD are aligned in the emission area EMA of the pixel PXL.

The first alignment electrode ALE1 may receive a first alignment signal at the step of aligning the light emitting elements LD. The second alignment electrode ALE2 and the additional second alignment electrode ALE2 each may receive a second alignment signal at the step of aligning the light emitting elements LD. The foregoing first and second alignment signals may be signals having a voltage difference and/or a phase difference, allowing the light emitting elements LD to be aligned between the alignment electrodes ALE. At least one of the first alignment signal or the second alignment signal may be an AC signal, but the present disclosure is not limited thereto.

The second alignment electrode ALE2, the first alignment electrode ALE1, and the additional second alignment electrode ALE2 each may be provided in the form of a bar having a constant width in at least the emission area EMA, but the present disclosure is not limited thereto. The second alignment electrode ALE2, the first alignment electrode ALE1, and the additional second alignment electrode ALE2 each may or may not have a bent portion in the non-emission area NEA. The shape, size, and/or the like thereof in the other areas except the emission area EMA may be changed in various ways without being particularly limited.

A bank pattern may be disposed under each of the alignment electrodes ALE so as to change a surface profile (or shape) of the alignment electrode ALE so that light emitted from the light emitting elements LD can be guided in an image display direction of the display device DD. The bank pattern will be described with reference to FIGS. 7 to 10.

Although at least two to several tens of light emitting elements LD may be aligned and/or provided in the emission area EMA (or the pixel area PXA), the number of light emitting elements LD is not limited thereto. The number of light emitting elements LD aligned and/or provided in the emission area EMA (or the pixel area PXA) may be changed in various ways.

The light emitting elements LD may be disposed between the second alignment electrode ALE2 and the first alignment electrode ALE1 and between the first alignment electrode ALE1 and the other second alignment electrode ALE2. In a plan view, each of the light emitting elements LD may include a first end EP1 and a second end EP2 that are located on respective opposite ends of the light emitting element LD in the longitudinal direction thereof, e.g., in the first direction DR1. The second semiconductor layer (refer to "13" of FIG. 1) including a p-type semiconductor layer may be disposed on the first end EP1 (or the p-type end), and the first semiconductor layer (refer to "11" of FIG. 1) including an n-type semiconductor layer may be disposed on the second end EP2 (or the n-type end). The light emitting elements LD may be electrically connected in parallel to each other between the second alignment electrode ALE2 and the first alignment electrode ALE1 and between the first alignment electrode ALE1 and the other second alignment electrode ALE2.

The light emitting elements LD may be disposed at positions spaced from each other and aligned in substantially parallel to each other. A distance by which the light emitting elements LD are spaced from each other is not particularly limited. A plurality of light emitting elements LD may be disposed adjacent to each other to form a group, and a plurality of additional light emitting elements LD may be spaced from each other at regular intervals to form a group. The light emitting elements LD may be aligned in one direction with an uneven density.

The light emitting elements LD may be input (or supplied) to the pixel area PXA (or the emission area EMA) by an inkjet printing scheme, a slit coating scheme, or other various schemes. For example, the light emitting elements LD may be mixed with a volatile solvent and then input (or supplied) to the pixel area PXA by the inkjet printing scheme or the slit coating scheme.

The light emitting elements LD may include a first light emitting element LD1 and a second light emitting element LD2.

The first light emitting element LD1 may be aligned between the right side of the first alignment electrode ALE1 and the other second alignment electrode ALE2 and electrically connected to the first electrode PE1 and the intermediate electrode CTE. The second light emitting element LD2 may be aligned between the left side of the first alignment electrode ALE1 and the second alignment electrode ALE2 and electrically connected to the intermediate electrode CTE and the second electrode PE2.

A plurality of first light emitting elements LD1 and a plurality of second light emitting elements LD2 may be provided. The first end EP1 of each of the first light emitting elements LD1 may be electrically connected to the first electrode PE1. The second end EP2 of each of the first light emitting elements LD1 may be electrically connected to the intermediate electrode CTE. The first end EP1 of each of the second light emitting elements LD2 may be electrically connected to the intermediate electrode CTE. The second end EP2 of each of the second light emitting elements LD2 may be electrically connected to the second electrode PE2.

The first light emitting elements LD1 may be connected in parallel to each other between the first electrode PE1 and the intermediate electrode CTE. The second light emitting elements LD2 may be connected in parallel to each other between the intermediate electrode CTE and the second electrode PE2.

The electrodes PE and the intermediate electrode CTE may be provided in at least the emission area EMA of the pixel PXL, and each may be provided at a position corresponding to at least one alignment electrode ALE and at least one light emitting element LD. For example, each electrode PE and each intermediate electrode CTE may be formed on the corresponding alignment electrodes ALE and the corresponding light emitting elements LD to overlap the alignment electrodes ALE and the light emitting elements LD, and thus electrically connected to at least the light emitting elements LD.

The electrodes PE may include a first electrode PE1 and a second electrode PE2.

The first electrode PE1 ("first pixel electrode" or "anode") may be formed on the right side of the first alignment electrode ALE1 and the respective first ends EP1 of the first light emitting elements LD1, and thus electrically connected to the respective first ends EP1 of the first light emitting elements LD1. The first electrode PE1 may have a bar shape having a constant width in an extension direction thereof, e.g., the second direction DR2.

The second electrode PE2 ("second pixel electrode" or "cathode") may be formed on the second alignment electrode ALE2 and the respective second ends EP2 of the second light emitting elements LD2, and thus electrically connected to the respective second ends EP2 of the second light emitting elements LD2. The second electrode PE2 may have a bar shape having a constant width in an extension direction thereof, e.g., the second direction DR2.

The intermediate electrode CTE may be formed on the second alignment electrode ALE2 and the respective second ends EP2 of the first light emitting elements LD1, and thus electrically connected to the respective second end EP2 of the first light emitting elements LD1. Furthermore, the intermediate electrode CTE may be formed on the left side of the first alignment electrode ALE1 and the respective first ends EP1 of the second light emitting elements LD2, and thus electrically connected to the respective first ends EP1 of the second light emitting elements LD2. To this end, the intermediate electrode CTE may have a bent shape. For example, the intermediate electrode CTE may have a bent or curved structure on a boundary between an area where at least one first light emitting element LD1 is disposed and an area where at least one second light emitting element LD2 is disposed.

The first electrode PE1, the intermediate electrode CTE, the second electrode PE2 may be spaced from each other in the emission area EMA.

In the foregoing scheme, the light emitting elements LD aligned between the alignment electrodes ALE may be connected to each other in a desired shape by using the first electrode PE1, the intermediate electrode CTE, and the second electrode PE2. For example, the first light emitting elements LD1 and the second light emitting elements LD2 may be successively electrically connected in series to each other by using the first electrode PE1, the intermediate electrode CTE, and the second electrode PE2.

The first electrode PE1 may be an anode of the emission component EMU. The second electrode PE2 may be a cathode of the emission component EMU.

The first electrode PE1 may contact the first alignment electrode ALE1 through a first contact hole CH1 in at least the non-emission area NEA, and may be electrically connected to the first alignment electrode ALE1. The first contact hole CH1 may be formed by opening a portion of at least one insulating layer disposed between the first electrode PE1 and the first alignment electrode ALE1. A portion of the first alignment electrode ALE1 may be exposed through the first contact hole CH1. Although the first contact hole CH1 that is a connection point (or a contact point) between the first electrode PE1 and the first alignment electrode ALE1 has been described as being located in the non-emission area NEA, the present disclosure is not limited thereto. The connection point (or the contact point) between the first electrode PE1 and the first alignment electrode ALE1 may be located in the emission area EMA of the pixel PXL.

The pixel circuit PXC, the first alignment electrode ALE1, and the first electrode PE1 may be electrically connected to each other through the second via hole VIH2 and the first contact hole CH1. Although in the foregoing the first alignment electrode ALE1 and the first electrode PE1 have been described as directly contacting each other through the first contact hole CH1, the present disclosure is not limited thereto. To prevent a defect due to material characteristics of the first alignment electrode ALE1 from occurring, the first electrode PE1 may directly contact the pixel circuit PXC rather than directly contacting the first alignment electrode ALE1, and be electrically connected to the pixel circuit PXC.

The second electrode PE2 may directly contact the second alignment electrode ALE2 through a second contact hole CH2 and may be electrically and/or physically connected with the second alignment electrode ALE2. The second contact hole CH2 may be formed by opening a portion of at least one insulating layer disposed between the second electrode PE2 and the second alignment electrode ALE2. A portion of the second alignment electrode ALE2 may be exposed through the second contact hole CH2. The second contact hole CH2 that is a connection point (or a contact point) between the second electrode PE2 and the second alignment electrode ALE2 may be located in the emission area EMA of the pixel PXL.

The second power line PL2, the second alignment electrode ALE2, and the second electrode PE2 may be electrically connected to each other through the first via hole VIH1 and the second contact hole CH2.

Although in the foregoing the second alignment electrode ALE2 and the second electrode PE2 have been described as directly contacting each other through the second contact hole CH2, the present disclosure is not limited thereto. To prevent a defect due to material characteristics of the second alignment electrode ALE2 from occurring, the second electrode PE2 may directly contact the second power line PL2 rather than directly contacting the second alignment electrode ALE2, and may be electrically connected to the second power line PL2.

Hereinafter, the stacked structure (or the cross-sectional structure) of the pixel PXL in accordance with the foregoing will be mainly described with reference to FIGS. 7 to 10.

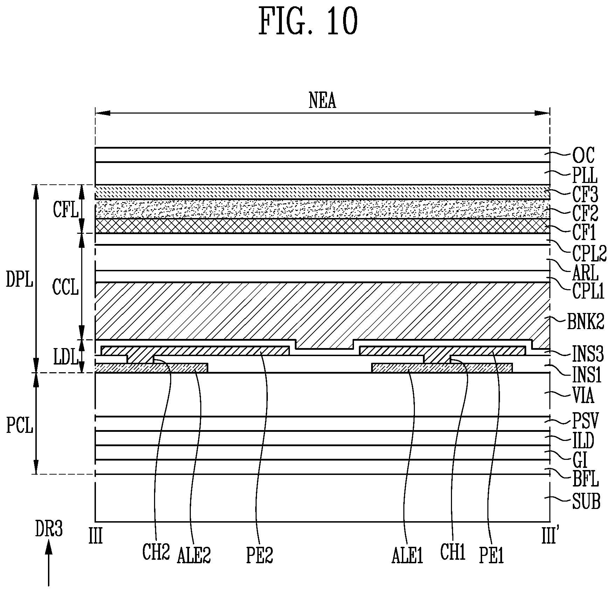

FIGS. 7 to 9 are schematic cross-sectional views taken along the line II-II' of FIG. 6. FIG. 10 is a schematic cross-sectional view taken along the line III-III' of FIG. 6.

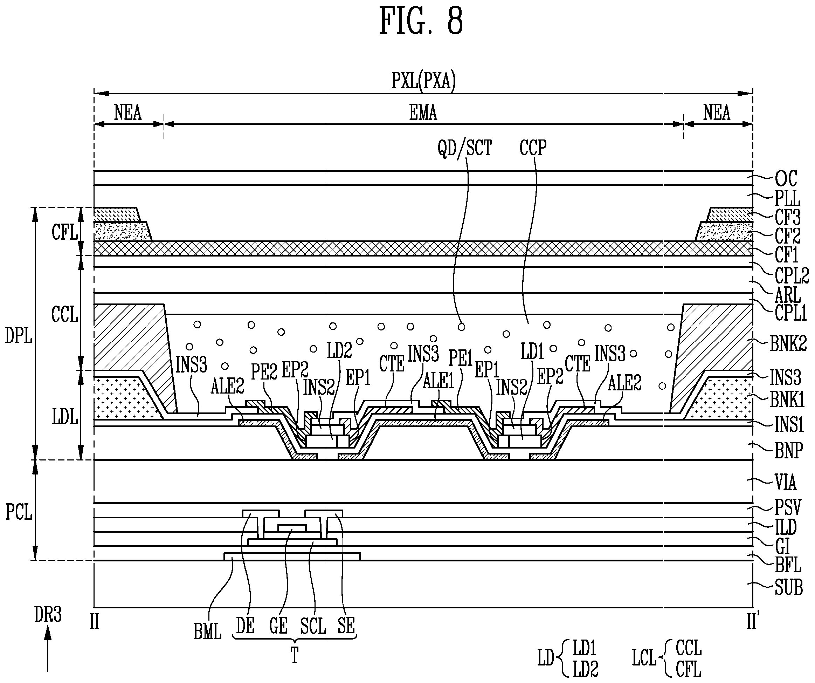

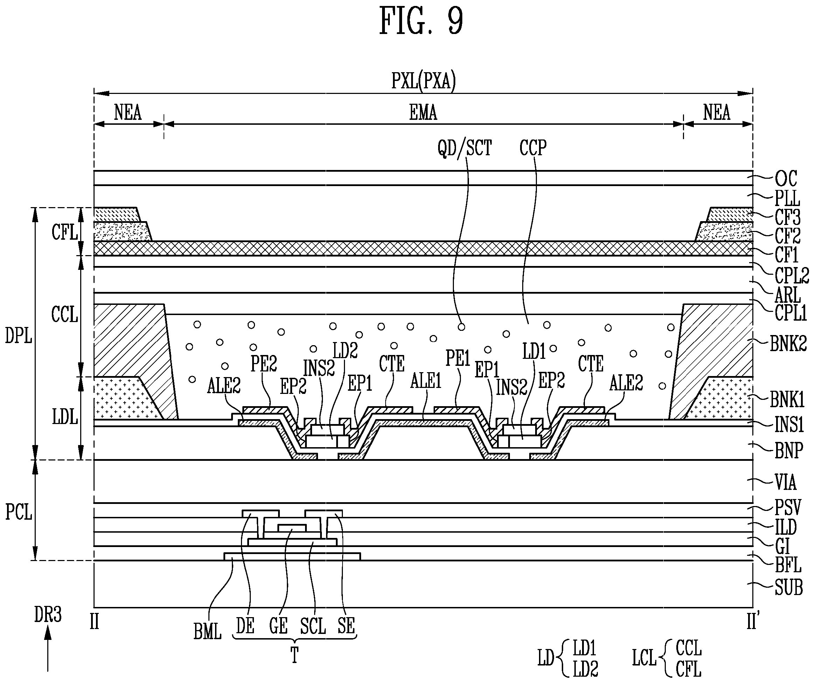

FIGS. 8 and 9 refer to modifications of the implementation of FIG. 7 pertaining both to the step of forming the first and second electrodes PE1 and PE2 and the intermediate electrode CTE and to whether a third insulating layer INS3 is present. For example, FIG. 8 illustrates an implementation where the first and second electrodes PE1 and PE2 are formed after the intermediate electrode CTE and the third insulating layer INS3 have been formed. FIG. 9 illustrates an implementation where the first and second electrodes PE1 and PE2 and the intermediate electrodes CTE are formed through the same process.

Although FIGS. 7 to 10 simply illustrate the stacked structure of the pixel PXL, e.g., illustrating that each electrode is formed of a single electrode and each insulating layer is formed of a single insulating layer, the present disclosure is not limited thereto.

The following description related to FIGS. 7 to 10 will be focused on differences from the above-mentioned implementations so as to avoid redundant description.

Referring to FIGS. 1 to 10, the pixel PXL may include a substrate SUB, a pixel circuit layer PCL, and a display element layer DPL.

The pixel circuit layer PCL and the display element layer DPL may be disposed on one surface of the substrate SUB and overlap each other. For example, the display area DA of the substrate SUB may include the pixel circuit layer PCL disposed on the one surface of the substrate SUB, and the display element layer DPL disposed on the pixel circuit layer PCL. However, relative positions of the pixel circuit layer PCL and the display element layer DPL on the substrate SUB may be changed. In case that the pixel circuit layer PCL and the display element layer DPL are separated from each other as separate layers and overlap each other, layout space sufficient to form each of the pixel circuit PXC and the emission component EMU on a plane may be secured.

The substrate SUB may include transparent insulating material to allow light transmission. The substrate SUB may be a rigid substrate or a flexible substrate.

In each pixel area PXA of the pixel circuit layer PCL, circuit elements (e.g., transistors T) for forming the pixel circuit PXC of the corresponding pixel PXL and signal lines electrically connected to the circuit elements may be disposed. Furthermore, the alignment electrodes ALE, the light emitting elements LD, and/or the electrodes PE that form the emission component EMU of the corresponding pixel PXL may be disposed in each pixel area PXA of the display circuit layer DPL.

The pixel circuit layer PCL may include at least one or more insulating layers as well as including the circuit elements and the signal lines. For example, the pixel circuit layer PCL may include a buffer layer BFL, a gate insulating layer GI, an interlayer insulating layer ILD, a passivation layer PSV, and a via layer VIA which are successively stacked on the substrate SUB in the third direction DR3.

The buffer layer BFL may be disposed on the overall surface of the substrate SUB. The buffer layer BFL may prevent impurities from diffusing into the transistors T included in the pixel circuit PXC. The buffer layer BFL may be an inorganic insulating layer including inorganic material. The buffer layer BFL may include at least one of silicon nitride (SiNₓ), silicon oxide (SiOₓ), silicon oxynitride (SiOₓN_{y}), or aluminum oxide (AlOₓ). Although the buffer layer BFL may be provided in a single-layer structure, the buffer layer BFL may be provided in a multi-layer structure having at least two or more layers. In the case where the buffer layer BFL has a multi-layer structure, the respective layers may be formed of the same material or different materials. The buffer layer BFL may be omitted depending on the material of the substrate SUB or processing conditions.

The gate insulating layer GI may be disposed on the overall surface of the buffer layer BFL. The gate insulating layer GI may include the same material as that of the buffer layer BFL, or include suitable (or selected) material from among the materials provided as examples of the constituent materials of the buffer layer BFL. The gate insulating layer GI may be an inorganic insulating layer including inorganic material.

The interlayer insulating layer ILD may be provided and/or formed on the overall surface of the gate insulating layer GI. The interlayer insulating layer ILD may include the same material as that of the buffer layer BFL, or include one or more suitable (or selected) materials selected from among the materials exemplified as the constituent materials of the buffer layer BFL.

The passivation layer PSV may be provided and/or formed on the overall surface of the interlayer insulating layer ILD. The passivation layer PSV may include the same material as that of the buffer layer BFL, or include one or more suitable (or selected) materials selected from among the materials provided as examples of the constituent materials of the buffer layer BFL.

The via layer VIA may be provided and/or formed on the overall surface of the passivation layer PSV. The via layer VIA may be an inorganic insulating layer including inorganic material or an organic insulating layer including organic material. The inorganic insulating layer may include, for example, at least one of silicon oxide (SiOₓ), silicon nitride (SiNₓ), silicon oxynitride (SiOₓN_{y}), or aluminum oxide (AlOₓ). The organic insulating layer may include, for example, at least one of polyacrylic resin, epoxy resin, phenolic resin, polyamide resin, polyimide rein, unsaturated polyester resin, poly-phenylen ether resin, polyphenylene sulfide resin, or benzocyclobutene resin. The via layer VIA may be an organic insulating layer.

The via layer VIA may include a plurality of via holes VIH. For example, the via layer VIA may be partially open to include first, second, and third via hole VIH1, VHI2, and VIH3.

The via layer VIA may be used as a planarization layer formed to mitigate a step difference that occurs due to components of the pixel circuit PXC that are disposed under the via layer VIA in the pixel circuit layer PCL.

The pixel circuit PXC may include at least one transistor T disposed on the buffer layer BFL. The transistor T may be a driving transistor configured to control driving current of the light emitting element LD, and have the same configuration as that of the first transistor T1 described with reference to FIG. 5.

The transistor T may include a semiconductor pattern SCL, a gate electrode GE that overlaps a portion of the semiconductor pattern SCL, and source and drain electrodes SE and DE that are electrically connected to the semiconductor pattern SCL.

The gate electrode GE may be provided and/or formed on the gate insulating layer GI. The gate electrode GE may overlap a portion of the semiconductor pattern SCL. For example, the gate electrode GE may overlap an active pattern of the semiconductor pattern SCL in the third direction DR3.

The semiconductor pattern SCL may be provided and/or formed on the buffer layer BFL. For example, the semiconductor pattern SCL may be disposed between the buffer layer BFL and the gate insulating layer GI. The semiconductor pattern SCL may be formed of poly silicon, amorphous silicon, an oxide semiconductor, and/or the like. The semiconductor pattern SCL may include an active pattern, a first contact area, and a second contact area. The active pattern, the first contact area, and the second contact area each may be formed of a semiconductor layer that is doped with no impurity or doped with an impurity. For example, the first contact area and the second contact area each may be formed of a semiconductor layer that is doped with an impurity, and the active pattern may be formed of an undoped semiconductor layer. For example, an n-type impurity may be used as the impurity, but the present disclosure is not limited thereto.

The active pattern of the semiconductor pattern SCL may be an area that overlaps the gate electrode GE of the transistor T in the third direction DR3, and may be a channel area. The first contact area of the semiconductor pattern SCL may contact one end of the active pattern. Furthermore, the first contact area may be electrically connected to the source electrode SE. The second contact area of the semiconductor pattern SCL may contact a remaining end of the active pattern. Furthermore, the second contact area may be electrically connected to the drain electrode DE.

The source electrode SE may be provided and/or formed on the interlayer insulating layer ILD. The source electrode SE may contact the first contact area of the semiconductor pattern SCL through a contact hole that passes through the gate insulating layer GI and the interlayer insulating layer ILD.

The drain electrode DE may be provided and/or formed on the interlayer insulating layer ILD. The drain electrode DE may be disposed on the interlayer insulating layer ILD at a position spaced from the source electrode SE. The drain electrode DE may contact the second contact area of the semiconductor pattern SCL through a contact hole that passes through the gate insulating layer GI and the interlayer insulating layer ILD.

A bottom metal pattern BML may be disposed under the first transistor T1 (or the transistor T).

The bottom metal pattern BML may be a first conductive layer disposed between the substrate SUB and the buffer layer BFL. The bottom metal pattern BML may be electrically connected to the transistor T. In this case, a driving range of a certain voltage to be applied to the gate electrode GE of the transistor T may be increased. The bottom metal pattern BML may be electrically connected to the semiconductor pattern SCL of the transistor T and stabilize the channel area of the transistor T. Furthermore, because the bottom metal pattern BML is electrically connected to the transistor T, the bottom metal pattern BML may be prevented from floating.

Although in the foregoing there has been illustrated the case where the transistor T is a thin-film transistor having a top gate structure, the present disclosure is not limited thereto. The structure of the transistor T may be changed in various ways.

The bottom metal pattern BML may have a single layer structure formed of one or combination selected from the group consisting of copper (Cu), molybdenum (Mo), tungsten (W), aluminum neodymium (AlNd), titanium (Ti), aluminum (Al), silver (Ag), and an alloy thereof, or may have a double layer or multilayer structure formed of molybdenum (Mo), titanium (Ti), copper (Cu), aluminum (Al), or silver (Ag) to reduce line resistance.

The passivation layer PSV and the via layer VIA may be successively disposed on the transistor T.

The display element layer DPL may be disposed on the via layer VIA.

The display element layer DPL may include a light-emitting-element layer LDL and an optical layer LCL. The optical layer LCL may include a color conversion layer CCL and a color filter layer CFL.

Components involved in aligning and driving the light emitting elements LD may be disposed in the light-emitting-element layer LDL. Components configured to convert light emitted from the light emitting element LD to light having excellent color reproducibility may be disposed in the color conversion layer CCL. Components configured to allow light emitted from the color conversion layer CCL to selectively pass therethrough may be disposed in the color filter layer CFL.

The light-emitting-element layer LDL may include bank patterns BNP, alignment electrodes ALE, a first bank BNK1, light emitting elements LD, electrodes PE, and/or an intermediate electrode CTE.

The bank patterns BNP may be disposed on the via layer VIA. For example, the bank patterns BNP may protrude in the third direction DR3 on one surface of the via layer VIA. Hence, one area of each of the alignment electrodes ALE disposed on the bank patterns BNP may protrude in the third direction DR3 (or the thickness direction of the substrate SUB).

The bank patterns BNP each may include an inorganic insulating layer including inorganic material or an organic insulating layer including organic material. The bank pattern BNP may include an organic insulating layer having a single layer structure and/or an inorganic insulating layer having a single layer structure, but the present disclosure is not limited thereto. The bank pattern BNP may be provided in a multi-layer structure formed by stacking at least one or more organic insulating layers and at least one or more inorganic insulating layers. However, the material of the bank pattern BNP is not limited to the foregoing. The bank pattern BNP may include a conductive material (or a conductive substance).

The bank pattern BNP may have a trapezoidal cross-section that is reduced in width from a surface (e.g., an upper surface) of the via layer VIA upward in the third direction DR3, but the present disclosure is not limited thereto. The bank pattern BNP may include a cross-sectional shape such as a semi-elliptical shape or a semi-circular shape (or a hemispherical shape) that is reduced in width from one surface of the via layer VIA upward in the third direction DR3. In a sectional view, the shape of the bank pattern BNP is not limited to the foregoing examples, and may be changed in various ways within a range in which the efficiency of light emitted from each of the light emitting elements LD can be enhanced. Furthermore, at least one of the bank patterns BNP may be omitted, or the position thereof may be changed.

The bank pattern BNP may be used as a reflector. For example, the bank pattern BNP, along with the alignment electrode ALE disposed thereover, may be used as a reflector to guide light emitted from each light emitting element LD in the image display direction of the display device DD (e.g., the third direction DR3), so that the light output efficiency of the pixel PXL can be enhanced.

The alignment electrodes ALE may be disposed on the bank pattern BNP.

The alignment electrodes ALE may be disposed on the same plane and have the same thickness with respect to the third direction DR3. The alignment electrodes ALE may be concurrently (e.g., simultaneously) formed through the same process.

The alignment electrodes ALE may be formed of material having a reflectivity to allow light emitted from the light emitting elements LD to travel in the image display direction (or a frontal direction) of the display device DD (e.g., the third direction DR3). For example, the alignment electrodes ALE may be formed of conductive material (or substance). The conductive material may include opaque metal that is suitable for reflecting, in the image display direction of the display device DD (e.g., the third direction DR3), light emitted from the light emitting elements LD. For example, the opaque metal may include a metal such as silver (Ag), magnesium (Mg), aluminum (Al), platinum (Pt), palladium (Pd), gold (Au), nickel (Ni), neodymium (Nd), iridium (Ir), chrome (Cr), titanium (Ti), and/or an alloy thereof. However, the material of the alignment electrodes ALE is not limited to the foregoing. The alignment electrodes ALE may include transparent conductive material (or substance). The transparent conductive material (or substance) may include transparent conductive oxides such as indium tin oxide (ITO), indium zinc oxide (IZO), zinc oxide (ZnOₓ), indium gallium zinc oxide (IGZO), and indium tin zinc oxide (ITZO), and a conductive polymer such as PEDOT (poly(3,4-ethylenedioxythiophene)). In case that the alignment electrodes ALE include transparent conductive material (or substance), a separate conductive layer formed of opaque metal for reflecting light emitted from the light emitting elements LD in the image display direction of the display device DD (e.g., the third direction DR3) may be added. However, the material of the alignment electrodes ALE is not limited to the foregoing materials.

As described above, in case that the alignment electrodes ALE are formed of conductive material having a reflectivity, light emitted from the opposite ends of each of the light emitting elements LD, i.e., the first and second ends EP1 and EP2, may more reliably travel in the image display direction of the display device DD (e.g., the third direction DR3).

A first insulating layer INS1 may be provided and/or formed on the alignment electrodes ALE.

The first insulating layer INS1 may be disposed on the alignment electrodes ALE and the via layer VIA. The first insulating layer INS1 may be partially open in at least the non-emission area NEA so that components disposed thereunder can be exposed. For example, the first insulating layer INS1 may be partially open to include a first contact hole CH1, which is formed by removing one area of the first insulating layer INS1 in at least the non-emission area NEA, and through which a portion of the first alignment electrode ALE1 is exposed, and a second contact hole CH2, which is formed by removing another area of the first insulating layer INS1 in at least the non-emission area NEA, and through which a portion of the second alignment electrode ALE2 is exposed.

The first insulating layer INS1 may be formed of an inorganic insulating layer made of inorganic material. The first insulating layer INS1 may have a single-layer or multi-layer structure. In the case in which the first insulating layer INS1 is provided in the form of a multi-layer structure, the first insulating layer INS1 may have a distributed Bragg reflector (DBR) structure formed by alternately stacking first inorganic layers and second inorganic layers that have different refractive indexes.

The first bank BNK1 may be disposed on the first insulating layer INS1.

The first bank BNK1 may be disposed on the first insulating layer INS1 in at least the non-emission area NEA, but the present disclosure is not limited thereto.

The first bank BNK1 and the bank pattern BNP may be formed through different processes and provided on different layers, but the present disclosure is not limited thereto. The first bank BNK1 and the bank pattern BNP may be formed through different processes and provided at the same layer, or may be formed through the same process and provided at the same layer.

The light emitting elements LD may be supplied to and aligned in the emission area EMA of the pixel PXL in which the first insulating layer INS1 and the first bank BNK1 are formed. For example, the light emitting elements LD may be supplied (or input) to the emission area EMA through the inkjet printing scheme or the like. The light emitting elements LD may be aligned between the alignment electrodes ALE by an electric field formed by a suitable signal (e.g., a predetermined signal or an alignment signal) applied to each of the alignment electrodes ALE. For example, the light emitting elements LD may be aligned on the first insulating layer INS1 between the first alignment electrode ALE1 and the second alignment electrode ALE2.

The light emitting elements LD may include a first light emitting element LD1 and a second light emitting element LD2.

The first light emitting element LD1 may be disposed between the right side of the first alignment electrode ALE1 and an additional second alignment electrode ALE2 adjacent to the right side of the first alignment electrode ALE1. The first light emitting element LD1 may include a first end EP1 that overlaps the first alignment electrode ALE1, and a second end EP2 that overlaps the additional second alignment electrode ALE2.

The second light emitting element LD2 may be disposed between the left side of the first alignment electrode ALE1 and the second alignment electrode ALE2 adjacent to the left side of the first alignment electrode ALE1. The second light emitting element LD2 may include a first end EP1 that overlaps the left side of the first alignment electrode ALE1, and a second end EP2 that overlaps the second alignment electrode ALE2.

A second insulating layer INS2 (or an insulating pattern) may be disposed on each of the first and second light emitting elements LD1 and LD2. The second insulating layer INS2 may be disposed on each of the first and second light emitting elements LD1 and LD2, and partially cover an outer surface (e.g., an outer peripheral or circumferential surface or a surface) of each of the first and second light emitting elements LD1 and LD2 so that the first end EP1 and the second end EP2 of each of the first and second light emitting elements LD1 and LD2 may be exposed to the outside.

The second insulating layer INS2 may include an inorganic insulating layer including inorganic material, or an organic insulating layer. For example, the second insulating layer INS2 may include an inorganic insulating layer suitable for protecting the active layer 12 of each of the first and second light emitting elements LD1 and LD2 from external oxygen, water, or the like. However, the present disclosure is not limited thereto. The second insulating layer INS2 may be formed of an organic insulating layer including organic material, depending on design conditions, and the like of the display device DD (or the display panel DP) to which the first and second light emitting elements LD1 and LD2 are applied. The second insulating layer INS2 may have a single-layer or multi-layer structure.

In the case in which a gap is present between the first insulating layer INS1 and the first and second light emitting elements LD1 and LD2 before the second insulating layer INS2 is formed, the gap may be filled with the second insulating layer INS2 during a process of forming the second insulating layer INS2.

Because the second insulating layer INS2 is formed on the light emitting elements LD that have been completely aligned in the emission area EMA of each pixel PXL, the light emitting elements LD may be prevented from being removed from the aligned positions.

Different electrodes selected from among the first electrode PE1, the second electrode PE2, and the intermediate electrode CTE may be formed on the first and second ends EP1 and EP2 of the light emitting elements LD that are not covered with the second insulating layer INS2. For example, the first electrode PE1 may be formed on the first end EP1 of the first light emitting element LD1. The intermediate electrode CTE may be formed on the second end EP2 of the first light emitting element LD1. The intermediate electrode CTE may be formed on the first end EP1 of the second light emitting element LD2. The second electrode PE2 may be formed on the second end EP2 of the second light emitting element LD2.

The first electrode PE1 may be disposed over the first alignment electrode ALE1 to overlap the right side of the first alignment electrode ALE1. The second electrode PE2 may be disposed over the second alignment electrode ALE2 to overlap the second alignment electrode ALE2 adjacent to the left side of the first alignment electrode ALE1. The intermediate electrode CTE may be disposed over each of the left side of the first alignment electrode ALE1 and an additional second alignment electrode ALE2 adjacent to the right side of the first alignment electrode ALE1.

The first electrode PE1 may be electrically connected to the first alignment electrode ALE1 through the first contact hole CH1 of the first insulating layer INS1. The second electrode PE2 may be electrically connected to the second alignment electrode ALE2 through the second contact hole CH2 of the first insulating layer INS1.

The first electrode PE1, the intermediate electrode CTE, and the second pixel electrode PE2 may be formed at the same layer or different layers. For example, relative positions and/or a formation sequence of the first electrode PE1, the intermediate electrode CTE, and the second pixel electrode PE2 may be changed in various ways.

In FIG. 7, the first and second electrodes PE1 and PE2 may be first formed on the second insulating layer INS2. The first electrode PE1 may directly contact the first end EP1 of the first light emitting element LD1 and may be electrically connected to the first light emitting element LD1. The second electrode PE2 may directly contact the second end EP2 of the second light emitting element LD2 and may be electrically connected to the second light emitting element LD2. The third insulating layer INS3 may be formed to cover the first and second electrodes PE1 and PE2.

The third insulating layer INS3 may be located on the first and second electrodes PE1 and PE2 and cover the first and second electrodes PE1 and PE2 (or prevent the first and second electrodes PE1 and PE2 from being exposed), thus protecting the first and second electrodes PE1 and PE2.

The third insulating layer INS3 may be formed of an inorganic insulating layer including inorganic material, or an organic insulating layer including organic material. The third insulating layer INS3 may have a single-layer or multi-layer structure.

The intermediate electrode CTE may be formed on the third insulating layer INS3. The intermediate electrode CTE may directly contact the second end EP2 of the first light emitting element LD1 and the first end EP1 of the second light emitting element LD2 and thus may be electrically connected between the first light emitting element LD1 and the second light emitting element LD2.

In FIG. 8, the intermediate electrode CTE may be first formed on the second insulating layer INS2. Thereafter, the third insulating layer INS3 may be formed to cover the intermediate electrode CTE. The first and second electrodes PE1 and PE2 may be formed in the emission area EMA in which the third insulating layer INS3 has been formed.

In the case where, as illustrated in the implementations of FIGS. 7 and 8, the electrodes that are disposed on the first end EP1 and the second end EP2 of each light emitting element LD are disposed in different layers, the electrodes may be reliably separated from each other, so that electrical stability between the first and second ends EP1 and EP2 of the light emitting elements LD can be secured.

In FIG. 9, the first electrode PE1, the intermediate electrode CTE, and the second electrode PE2 may be disposed at the same layer, and may be concurrently (e.g., simultaneously) or sequentially formed. The third insulating layer INS3 may be omitted. In an implementation of FIG. 9, in the case where the electrodes that are disposed on the first end EP1 and the second end EP2 of each light emitting element LD are disposed at the same layer and concurrently (e.g., simultaneously) formed, a process of fabricating the pixel PXL may be facilitated, and the process efficiency may be enhanced.

The first electrode PE1, the second electrode PE2, and the intermediate electrode CTE each may be formed of various transparent conductive materials. For example, the first electrode PE1, the second electrode PE2, and the intermediate electrode CTE each may include at least one of various transparent conductive materials including indium tin oxide (ITO), indium zinc oxide (IZO), indium tin zinc oxide (ITZO), aluminum zinc oxide (AZO), gallium zinc oxide (GZO), zinc tin oxide (ZTO), or gallium tin oxide (GTO), and may be substantially transparent or translucent to provide satisfactory transmittance. Hence, light emitted from the first and second ends EP1 and EP2 of the light emitting elements LD may pass through the electrodes PE and the intermediate electrode CTE and then may be emitted out of the display device DD (or the display panel DP).

The color conversion layer CCL is disposed on the light-emitting-element layer LDL.

The color conversion layer CCL may include a second bank BNK2, a color conversion pattern CCP, a first capping layer CPL1, a low refractive layer ARL, and a second capping layer CPL2.

The second bank BNK2 may be provided and/or formed on the first bank BNK1 and the third insulating layer INS3 in the non-emission area NEA. The second bank BNK2 may be a dam structure that encloses the emission area EMA of the pixel PXL and defines a position at which the color conversion pattern CCP is to be supplied, thus eventually defining the emission area EMA.

The second bank BNK2 may include light blocking material. For example, the second bank BNK2 may be a black matrix, but the present disclosure is not limited thereto. The second bank BNK2 may include at least one light blocking material and/or reflective material, and allow light emitted from the color conversion pattern CCP to more reliably travel in the image display direction of the display device DD (e.g., the third direction DR3), thus enhancing the light output efficiency of the color conversion pattern CCP.

The color conversion pattern CCP may be formed on the first electrode PE1, the intermediate electrode CTE, and the second electrode PE2 of each pixel PXL covered by the third insulating layer INS3 in the emission area EMA that is enclosed by the second bank BNK2.

The color conversion pattern CCP may include color conversion particles QD corresponding to a specific color. For example, the color conversion pattern CCP may include color conversion particles QD that convert a first color of light emitted from the light emitting elements LD to a second color of light (a specific color of light, or light having excellent color reproducibility).

In the case in which the pixel PXL is a red pixel (or a red sub-pixel), the color conversion pattern CCP of the pixel PXL may include color conversion particles QD formed of red quantum dots that convert a first color of light emitted from the light emitting elements LD to a second color of light (e.g., red light).

In the case in which the pixel PXL is a green pixel (or a green sub-pixel), the color conversion pattern CCP of the pixel PXL may include color conversion particles QD formed of green quantum dots that convert a first color of light emitted from the light emitting elements LD to a second color of light (e.g., green light).

In the case in which the pixel PXL is a blue pixel (or a blue sub-pixel), the color conversion pattern CCP of the pixel PXL may include color conversion particles QD formed of blue quantum dots that convert a first color of light emitted from the light emitting elements LD to a second color of light (e.g., blue light). In the case in which the pixel PXL is a blue pixel (or a blue sub-pixel), there may be provided a light scattering layer (refer to "LSL" of FIG. 11) having light scattering particles SCT, in place of the color conversion pattern CCP having the color conversion particles QD. For example, in the case that the light emitting elements LD emit blue-based light, the pixel PXL may include a light scattering layer LSL including light scattering particles SCT. The light scattering layer LSL may be omitted. In the case in which the pixel PXL is a blue pixel (or a blue sub-pixel), there may be provided a transparent polymer, in place of the color conversion pattern CCP.

The first capping layer CPL1 may be disposed on the color conversion pattern CCP and the second bank BNK2.

The first capping layer CPL1 may be provided on the overall surface of the display area DA, in which the pixel PXL is disposed, to cover the second bank BNK2 and the color conversion pattern CCP. Furthermore, the first capping layer CPL1 may also be provided in the non-display area NDA.

The first capping layer CPL1 may be an inorganic insulating layer including inorganic material. The first capping layer CPL1 may include at least one of silicon nitride (SiNₓ), silicon oxide (SiOₓ), silicon oxynitride (SiOₓN_{y}), aluminum oxide (AlOₓ), or the like. The first capping layer CPL1 may cover the entireties of the second bank BNK2 and the color conversion pattern CCP and thus prevent external water or moisture from being drawn into the color conversion layer CCL.

The low refractive layer ARL (low refractive index layer ARL) may be disposed on the first capping layer CPL1.

The low refractive layer ARL (or a low refractive index layer) may change, using a difference in refractive index, a path of light emitted from the color conversion pattern CCP to the front direction (or the image display direction of the display device DD (e.g., the third direction DR3)), thus enhancing frontal output light luminance. The low refractive layer ARL may recycle light (e.g., blue-based light) that does not react with the color conversion pattern CCP so that the light can react with the color conversion pattern CCP, whereby the output light luminance of the color conversion pattern CCP can be increased.

The low refractive layer ARL may include resin and hollow particles dispersed in the resin and have a refractive index ranging from 1.1 to 1.3, but the present disclosure is not limited thereto. Here, the hollow particles may refer to particles each having a form in which space is present in a surface and/or interior of an organic or inorganic particle. The hollow particles may be hollow silica particles. "The hollow silica particles" may be silica particles extracted from a silicide or an organic silicide, and refer to particles each having a form in which space is present in a surface and/or interior of a silica particle. The low refractive layer ARL may include an anti-reflection layer formed by alternately stacking layers made of materials having different refractive indexes. In this case, each layer may be formed of an organic insulating layer including organic material, but the present disclosure is not limited thereto. Each layer may be formed of an inorganic insulating layer including inorganic material. The low refractive layer ARL may be formed to selectively reflect light of a specific wavelength range. For example, the low refractive layer ARL may be configured to allow light having a first wavelength from among light that travels toward a rear surface of the color conversion pattern CCP to pass therethrough, and may be configured to reflect light having a wavelength different from the first wavelength.

The low refractive layer ARL may be formed of inkjet type material that can be applied to a desired portion by the inkjet printing scheme.

A second capping layer CPL2 may be disposed on the low refractive layer ARL.

The second capping layer CPL2 may be an inorganic insulating layer including inorganic material. The second capping layer CPL2 may include the same material as that of the first capping layer CPL1, or may include one or more suitable (or selected) materials from among materials provided as examples of the constituent material of the first capping layer CPL1. The second capping layer CPL2 may cover the entirety of the low refractive layer ARL.

The color filter layer CFL may be disposed on the second capping layer CPL2. The color filter layer CFL may include a color filter pattern corresponding to the emission area EMA of each pixel PXL. For example, the color filter layer CFL may include a first color filter pattern CF1 disposed on the color conversion pattern CCP of one pixel PXL (hereinafter, referred to as "first pixel"), a second color filter pattern CF2 disposed on the color conversion pattern of an adjacent pixel (hereinafter, referred to as "second pixel") adjacent to the first pixel PXL, and a third color filter pattern CF3 disposed on the color conversion layer of an adjacent pixel (hereinafter, referred to as "third pixel") adjacent to the second pixel.

The first, second, and third color filter patterns CF1, CF2, and CF3 may be disposed in the non-emission area NEA and overlap each other, thus functioning as a light blocking component for preventing optical interference between adjacent pixels PXL from occurring. The first, second, and third color filter patterns CF1, CF2, and CF3 each include color filter material that allows the second color of light converted by the corresponding color conversion pattern to selectively pass therethrough. According to the invention, first color filter pattern CF1 is a red color filter, the second color filter pattern CF2 is a green color filter, and the third color filter pattern CF3 is a blue color filter, but the present disclosure is not limited thereto.

A planarization layer PLL may be disposed on the color filter layer CFL.

The planarization layer PLL may cover the color filter layer CFL. The planarization layer PLL may function to mitigate a step difference formed by components of the display element layer DPL located therebelow.

The overcoat layer OC may be disposed on the planarization layer PLL.

The overcoat layer OC may cover a lower component including the planarization layer PLL. The overcoat layer OC may prevent water or oxygen from permeating the lower component. Furthermore, the overcoat layer OC may protect the lower component from foreign material such as dust. The overcoat layer OC may be formed of inkjet type material which can be applied to a desired portion by the inkjet printing scheme.

FIGS. 11 to 16 are schematic cross-sectional views taken along the line I-I' of FIG. 3.

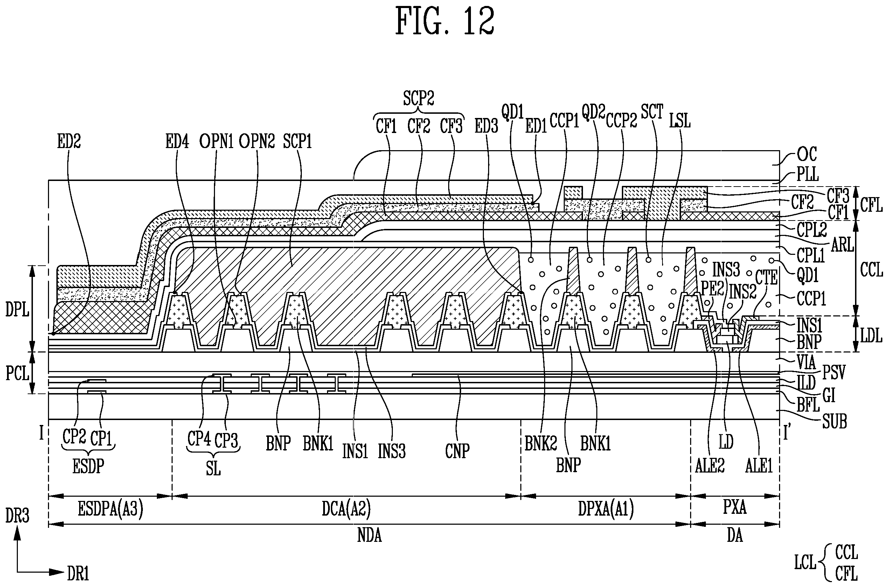

Implementations of FIGS. 12 to 16 may refer to modifications of an implementation of FIG. 11 with regard to some components disposed in the non-display areas NDA.

The following description related to FIGS. 11 to 16 will be focused on differences from the above-mentioned implementations so as to avoid redundant description.

Referring to FIGS. 3, and 11 to 16, the substrate SUB may include a display area DA and a non-display area NDA.

The display area DA may include a pixel area PXA in which the pixels PXL are disposed. The substrate SUB, the pixel circuit layer PCL, the display element layer DPL, the planarization layer PLL, and the overcoat layer OC may be provided in the pixel area PXA. The pixel circuit layer PCL may also be provided in the non-display area NDA.

The non-display area NDA may include a dummy pixel area DPXA, a driving circuit area DCA, and an antistatic circuit area ESDPA. The non-display area NDA may be sectioned into a first area A1 adjacent to the display area DA, a second area A2 adjacent to the first area A1, and a third area A3 adjacent to the second area A2. The first area A1 may correspond to the dummy pixel area DPXA. The second area A2 may correspond to the driving circuit area DCA. The third area A3 may correspond to the antistatic circuit area ESDPA.

A dummy pixel DPXL may be disposed in the dummy pixel area DPXA (or the first area A1). The dummy pixel area DPXA may be disposed closer to the display area DA than the driving circuit area DCA and the antistatic circuit area ESDPA are.

The substrate SUB, the pixel circuit layer PCL, the display element layer DPL, the planarization layer PLL, and the overcoat layer OC may be provided in the dummy pixel area DPXA.

The color conversion layer CCL and the color filter layer CFL may be provided in the display element layer DPL of the dummy pixel area DPXA. Only some components of the light-emitting-element layer LDL may be provided in the display element layer DPL of the dummy pixel area DPXA. For example, the alignment electrodes ALE, the electrodes PE, the intermediate electrode CTE, and the light emitting elements LD may not be provided in the dummy pixel area DPXA, but the present disclosure is not limited thereto. The alignment electrodes ALE, the electrodes PE, the intermediate electrode CTE, and the light emitting elements LD may also be provided in the dummy pixel area DPXA.

The light-emitting-element layer LDL of the dummy pixel area DPXA may include a bank pattern BNP, a first insulating layer INS1, a first bank BNK1, and a third insulating layer INS3 that are successively stacked in the third direction DR3 from one surface of the via layer VIA. The bank pattern BNP, the first insulating layer INS1, the first bank BNK1, and the third insulating layer INS3 may be the bank pattern BNP, the first insulating layer INS1, the first bank BNK1, and the third insulating layer INS3 that have been described with reference to FIGS. 7 to 10.

The first insulating layer INS1 may be disposed on the bank pattern BNP and cover the bank pattern BNP. The third insulating layer INS3 may be disposed on the first bank BNK1 and cover the first bank BNK1. The first bank BNK1 may be disposed on the bank pattern BNP with the first insulating layer INS1 interposed therebetween, and overlap the bank pattern BNP.

The color conversion layer CCL of the dummy pixel area DPXA may include first and second color conversion patterns CCP1 and CCP2, a light scattering layer LSL, a second bank BNK2, a first capping layer CPL1, a low refractive layer ARL, and a second capping layer CPL2. Each of the first and second color conversion patterns CCP1 and CCP2 may be the color conversion pattern CCP described with reference to FIGS. 7 to 10. The second bank BNK2, the first capping layer CPL1, the low refractive layer ARL, and the second capping layer CPL2 may respectively correspond to the second bank BNK2, the first capping layer CPL1, the low refractive layer ARL, and the second capping layer CPL2 that have been described with reference to FIGS. 7 to 10.

The first color conversion pattern CCP1 may include first color conversion particles QD1. For example, the first color conversion particles QD1 may be red quantum dots. The first color conversion pattern CCP1 may include a plurality of first color conversion particles QD1 that are dispersed in a matrix material such as base resin.

The second color conversion pattern CCP2 may include second color conversion particles QD2. For example, the second color conversion particles QD2 may be green quantum dots. The second color conversion pattern CCP2 may include a plurality of second color conversion particles QD2 that are dispersed in a matrix material such as base resin.

The light scattering layer LSL may include light scattering particles SCT. For example, the light scattering layer LSL may include a plurality of light scattering particles SCT that are dispersed in a matrix material such as base resin. The light scattering layer LSL may include light scattering particles SCT formed of material such as silica, but the constituent material of the light scattering particles SCT is not limited thereto. The light scattering particles SCT may be omitted, and the light scattering layer LSL may be formed of transparent polymer.

The color filter layer CFL of the dummy pixel area DPXA may include a first color filter pattern CF1, a second color filter pattern CF2, and a third color filter pattern CF3. The first color filter pattern CF1, the second color filter pattern CF2, and the third color filter pattern CF3 may respectively correspond to the first color filter pattern CF1, the second color filter pattern CF2, and the third color filter pattern CF3 that have been described with reference to FIGS. 7 to 10.

A planarization layer PLL and an overcoat layer OC may be disposed on the color filter layer CFL. The planarization layer PLL and the overcoat layer OC may respectively correspond to the planarization layer PLL and the overcoat layer OC that have been described with reference to FIGS. 7 to 10.

The dummy pixel DPXL disposed in the dummy pixel area DPXA may include a first sub-pixel, a second sub-pixel, and a third sub-pixel. The first color conversion pattern CCP1 and the first color filter pattern CF1 may be located in the first sub-pixel. The second color conversion pattern CCP2 and the second color filter pattern CF2 may be located in the second sub-pixel. The light scattering layer LSL and the third color filter pattern CF3 may be located in the third sub-pixel.

In the driving circuit area DCA (or the second area A2), an internal circuit, signal lines SL electrically connected to the internal circuit, and a connection pattern CNP may be disposed. The driving circuit area DCA may be located between the antistatic circuit area ESDPA and the dummy pixel area DPXA, and may be located closer to the display area DA than the antistatic circuit area ESDPA is.

The signal lines SL may include fan-out lines that are electrically connected to the pixels PXL and are configured to transmit signals to be applied from the internal circuit (or the driver) to the pixels PXL. Each of the signal lines SL may be implemented as a double-layer structure in which a third conductive pattern CP3 and a fourth conductive pattern CP4 that are disposed in different layers are electrically connected to each other, but the present disclosure is not limited thereto. The third conductive pattern CP3 may be disposed on the substrate SUB. The fourth conductive pattern CP4 may be disposed on the interlayer insulating layer ILD.

The connection pattern CNP may be disposed on the interlayer insulating layer ILD. The connection pattern CNP may electrically connect the pixel PXL to a power electrode configured to provide a voltage of the first driving power supply (refer to "VDD" of FIG. 5) or the second driving power supply (refer to "VSS" of FIG. 5). The connection pattern CNP may be provided over the driving circuit area DCA, the dummy pixel area DPXA, and the display area DA.

Some components of the display element layer DPL may be disposed in the driving circuit area DCA. For example, a bank pattern BNP, a first insulating layer INS1, a first bank BNK1, and a third insulating layer INS3 may be disposed in the driving circuit area DCA. The bank pattern BNP, the first insulating layer INS1, the first bank BNK1, and the third insulating layer INS3 may have respectively the same configurations as the bank pattern BNP, the first insulating layer INS1, the first bank BNK1, and the third insulating layer INS3 that are disposed in the dummy pixel area DPXA.

A first step difference compensation pattern SCP1 may be disposed in the driving circuit area DCA.

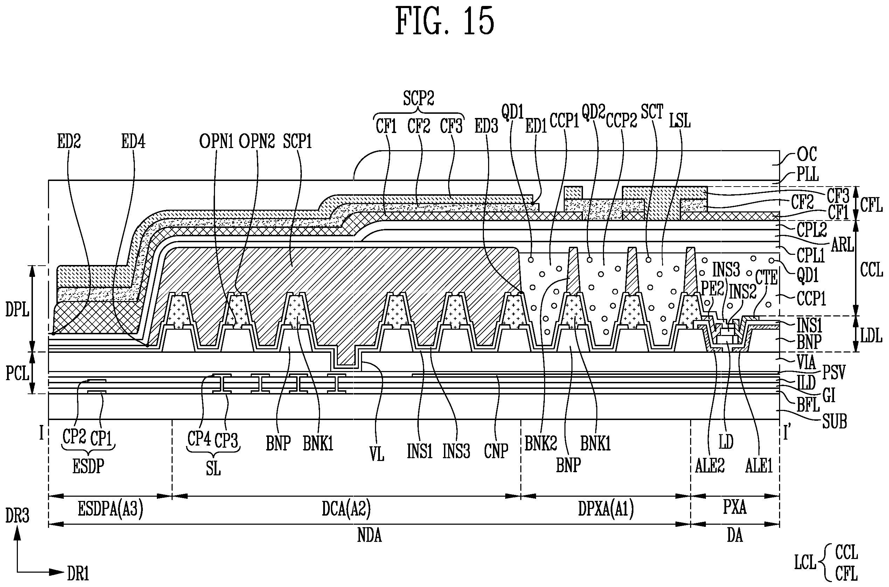

The first step difference compensation pattern SCP1 may be disposed on the third insulating layer INS3 and cover the third insulating layer INS3 and components (or lower components) disposed therebelow. The first step difference compensation pattern SCP1 may include a third end ED3 (or one end) and a fourth end ED4 (or a remaining end) that are opposite each other. The third end ED3 may be located adjacent to the dummy pixel area DPXA. The fourth end ED4 may be located adjacent to the antistatic circuit area ESDPA. For example, the third end ED3 of the first step difference compensation pattern SCP1 may be located on the third insulating layer INS3 on the first bank BNK1 located between (in a boundary between) the dummy pixel area DPXA and the driving circuit area DCA. The fourth end ED4 of the first step difference compensation pattern SCP1 may be located on the third insulating layer INS3 on the first bank BNK1 located closest to the antistatic circuit area ESDPA. However, the location of the first step difference compensation pattern SCP1 is not limited to the foregoing. As illustrated in FIG. 15, the fourth end ED4 of the first step difference compensation pattern SCP1 may extend to the antistatic circuit area ESDPA and may be located over the first bank BNK1 located closest to the antistatic circuit area ESDPA in the driving circuit area DCA to completely cover the first bank BNK1.

The first step different compensation pattern SCP1 may be provided over the entirety of the driving circuit area DCA, and may have a planar surface (or a planar upper surface). The first step different compensation pattern SCP1 may mitigate a step difference formed by components disposed in the driving circuit area DCA and thus enhance step coverage of components (or upper components) to be disposed over the first step difference compensation pattern SCP1.

The first step difference compensation pattern SCP1 may include light blocking material. For example, the first step difference compensation pattern SCP1 may be formed of a black matrix, but the present disclosure is not limited thereto. The first step difference compensation pattern SCP1 may include the same material as that of the second bank BNK2 located in the dummy pixel area DPXA and the display area DA (or the pixel area PXA).

A first capping layer CPL1 may be disposed on the first step difference compensation pattern SCP1. The first capping layer CPL1 may be the first capping layer CPL1 disposed in the dummy pixel area DPXA. The first capping layer CPL1 may completely cover the first step difference compensation pattern SCP1. Hence, the first capping layer CPL1 may prevent external water, oxygen, or the like from being drawn into the first step difference compensation pattern SCP1.

A low refractive layer ARL may be disposed on the first capping layer CPL1. The low refractive layer ARL may be the low refractive layer ARL disposed in the dummy pixel area DPXA.

The low refractive layer ARL may be made of inkjet type material having fluidity and may be formed by the inkjet printing scheme. In the case where the inkjet type material is applied onto the first capping layer CPL1, the inkjet type material may move to an undesired area (e.g., the antistatic circuit area ESDPA or an edge of the substrate SUB) due to characteristics of the inkjet type material. However the first step difference compensation pattern SCP1 located under the first capping layer CPL1 may be provided over the entirety of the driving circuit area DCA and have a planar surface so that the flow rate of the inkjet type material can be controlled, whereby the inkjet type material may be prevented from moving to the undesired area. Hence, the low refractive layer ARL formed by hardening the inkjet type material may be provided in only some areas of the driving circuit area DCA rather than being provided in the entirety of the driving circuit area DCA. For example, the low refractive layer ARL may be disposed on the first capping layer CPL1 on one area of the first step difference compensation pattern SCP1 to overlap the one area of the first step difference compensation pattern SCP1. Although, in a cross-sectional view, an end of the low refractive layer ARL is located adjacent to a central portion of the driving circuit area DCA, the present disclosure is not limited thereto.

A second capping layer CPL2 may be disposed on the low refractive layer ARL. The second capping layer CPL2 may be the second capping layer CPL2 disposed in the dummy pixel area DPXA. The second capping layer CPL2 may completely cover the low refractive layer ARL and protect the low refractive layer ARL. The second capping layer CPL2 along with the first capping layer CPL1 may completely cover the first step difference compensation pattern SCP1. Hence, the second capping layer CPL2 may more reliably prevent external water or oxygen from being drawn into the first step difference compensation pattern SCP1, thus enhancing the reliability of the first step difference compensation pattern SCP1.

A second step-difference compensation pattern SCP2 may be disposed on the second capping layer CPL2. The second step difference compensation pattern SCP2 may include a first color filter pattern CF1, a second color filter pattern CF2, and a third color filter pattern CF3 that are successively stacked on the second capping layer CPL2 in the third direction DR3. The first color filter pattern CF1 may be a red color filter, the second color filter pattern CF2 may be a green color filter, and the third color filter pattern CF3 may be a blue color filter. The first color filter pattern CF1 may be the first color filter pattern CF1 disposed in the first sub-pixel of the dummy pixel area DPXA. The second color filter pattern CF2 may be the second color filter pattern CF2 disposed in the second sub-pixel of the dummy pixel area DPXA. The third color filter pattern CF3 may be the third color filter pattern CF3 disposed in the third sub-pixel of the dummy pixel area DPXA.

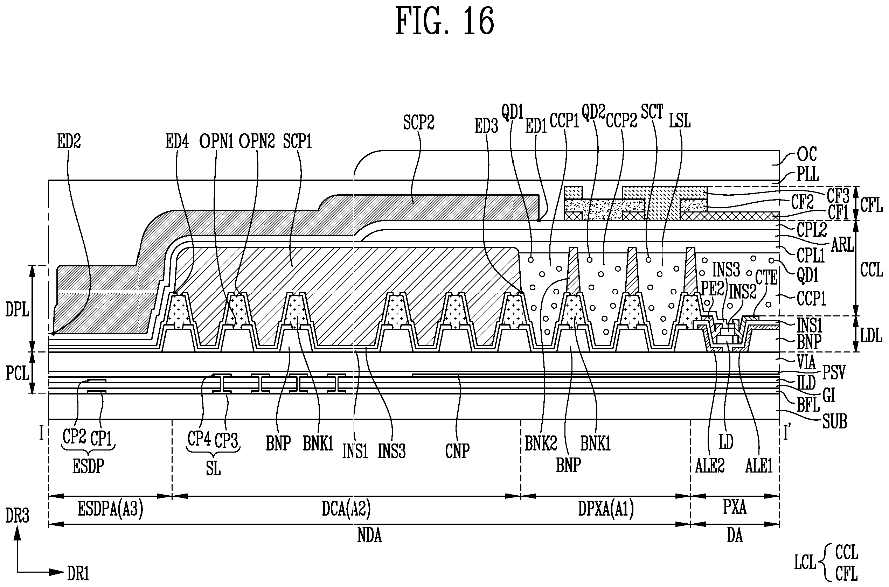

According to the invention, the second step difference compensation pattern SCP2 includes the same material as that of the first, second, and third color filter patterns CF1, CF2, and CF3 that form the color filter layer CFL of the display area DA. However, the present disclosure is not limited thereto. According to embodiments not falling within the scope of the invention, second step difference compensation pattern SCP2 may include material different from that of the first, second, and third color filter patterns CF1, CF2, and CF3. For example, as illustrated in FIG. 16, the second step difference compensation pattern SCP2 may be formed of a separate configuration from the first, second, and third color filter patterns CF1, CF2, and CF3. For example, the second step difference compensation pattern SCP2 may be formed of a black matrix.

The second step difference compensation pattern SCP2 may be provided to the entireties of the driving circuit area DCA and the antistatic circuit area ESDPA. The second step difference compensation pattern SCP2 may be disposed on the second capping layer CPL2 and cover the second capping layer CPL2 and components disposed therebelow. The second step difference compensation pattern SCP2 may include a first end ED1 (or one end) and a second end ED2 (or a remaining end) that are opposite each other. The first end ED1 may be located closer to the display area DA than the third end ED3 of the first step difference compensation pattern SCP1 is, and the second end ED2 may be located more outside than the fourth end ED4 of the first step difference compensation pattern SCP1 is, so that the second step difference compensation pattern SCP2 can completely cover the fourth end ED4 of the first step difference compensation pattern SCP1.

The second step different compensation pattern SCP2 may be provided over the entireties of the driving circuit area DCA and the antistatic circuit area ESDPA, and may have a planar surface (or a planar upper surface). The second step different compensation pattern SCP2 may mitigate a step difference formed by components disposed in the driving circuit area DCA and the antistatic circuit area ESDPA and thus enhance step coverage of components to be disposed over the second step difference compensation pattern SCP2.

A planarization layer PLL may be disposed on the second step difference compensation pattern SCP2. The planarization layer PLL may be the same as the planarization layer PLL of the dummy pixel area DPXA. The planarization layer PLL may be disposed on the second step difference compensation pattern SCP2 and completely cover the second step difference compensation pattern SCP2. Hence, the planarization layer PLL may prevent external water, oxygen, or the like from being drawn into the second step difference compensation pattern SCP2. The planarization layer PLL may be provided in the entireties of the display area DA and the non-display area NDA, and may have a planar surface (or a planar upper surface).

An overcoat layer OC may be disposed on the planarization layer PLL. The overcoat layer OC may be the overcoat layer OC disposed in the dummy pixel area DPXA.

The overcoat layer OC may be made of inkjet type material having fluidity and be formed by the inkjet printing scheme. In the case where the inkjet type material is applied onto the planarization layer PLL, the inkjet type material may move to an undesired area (e.g., the antistatic circuit area ESDPA or an edge of the substrate SUB) due to characteristics of the inkjet type material. However, the planarization layer PLL and the second step difference compensation pattern SCP2 may be provided over the entirety of the driving circuit area DCA and have a planar surface so that the flow rate of the inkjet type material can be controlled, whereby the inkjet type material may be prevented from moving to the undesired area. Hence, the overcoat layer OC formed by hardening the inkjet type material may be provided in only some areas of the driving circuit area DCA rather than being provided in the entirety of the driving circuit area DCA. For example, the overcoat layer OC may be disposed on the planarization layer PLL on one area of the second step difference compensation pattern SCP2 to overlap the one area of the second step difference compensation pattern SCP2. Although, in a cross-sectional view, an end of the overcoat layer OC is located adjacent to a central portion of the driving circuit area DCA, the present disclosure is not limited thereto. The end of the overcoat layer OC may be located closer to the display area DA than the fourth end ED4 of the first step difference compensation pattern SCP1 is.

An antistatic circuit ESDP may be disposed in the antistatic circuit area ESDPA. The antistatic circuit area ESDPA may be disposed closer to the driving circuit area DCA and the dummy pixel area DPXA than is to the display area DA.

The antistatic circuit ESDP may prevent a pulse potential caused from static electricity from being applied to an internal circuit, e.g., the pixel circuit (refer to "PXC" of FIG. 5). The antistatic circuit ESDP may be designed to have a low impedance in a high-voltage area so that the antistatic circuit ESDP allows overcurrent to be discharged or may be self-destructed, thus preventing inflow of static electricity, and may be designed to have a high impedance under normal driving conditions and thus prevent an influence on a signal to be supplied through the signal lines SL. The antistatic circuit ESDP may include a first conductive pattern CP1 disposed on the substrate SUB, and a second conductive pattern CP2 disposed on the gate insulating layer GI. The first and second conductive patterns CP1 and CP2 may be connected between the signal lines SL and a common line so that a pulse caused from static electricity drawn into the data line (refer to "Dj" of FIG. 5) of the display area DA can be dispersed to the common line.

The first insulating layer INS1, the third insulating layer INS3, the first and second capping layers CPL1 and CPL2, the second step difference compensation pattern SCP2, and the planarization layer PLL may be disposed in the antistatic circuit area ESDPA.

As described above, the insulating layers of the display area DA, e.g., the buffer layer BFL, the gate insulating layer GI, the interlayer insulating layer ILD, the passivation layer PSV, the via layer VIA, the first insulating layer INS1, the third insulating layer INS3, the first capping layer CPL1, the second capping layer CPL2, and the planarization layer PLL, may extend to the non-display area NDA. In other words, the buffer layer BFL, the gate insulating layer GI, the interlayer insulating layer ILD, the passivation layer PSV, the via layer VIA, the first insulating layer INS1, the third insulating layer INS3, the first capping layer CPL1, the second capping layer CPL2, and the planarization layer PLL may be common layers provided in common in the display area DA and the non-display area NDA.

The first insulating layer INS1 and the third insulating layer INS3 that are common layers may be partially open, as illustrated in FIGS. 12 to 16, so that some of components disposed therebelow can be exposed. For example, the first insulating layer INS1 may be partially open to include, in the display area DA and the non-display area NDA, first openings OPN1 through each of which one area of the bank pattern BNP is exposed. The third insulating layer INS3 may be partially open to include, in the display area DA and the non-display area NDA, second openings OPN2 through each of which one area of the first bank BNK1 is exposed. In this case, the bank pattern BNP and the first bank BNK1 each may be formed of an organic insulating layer. The bank pattern BNP exposed through the first opening OPN1 may be connected to ("brought into contact with" or "abut on") the first bank BNK1. The first bank BNK1 exposed through the second opening OPN2 may be connected to the second bank BNK2 in the display area DA, and may be connected to the first step difference compensation pattern SCP1 in the non-display area NDA. Each of the second bank BNK2 and the first step difference compensation pattern SCP1 may be used as an outlet for discharging (or releasing) outgas that occurs from the first and third insulating layers INS1 and INS3 each of which is formed of an organic insulating layer.

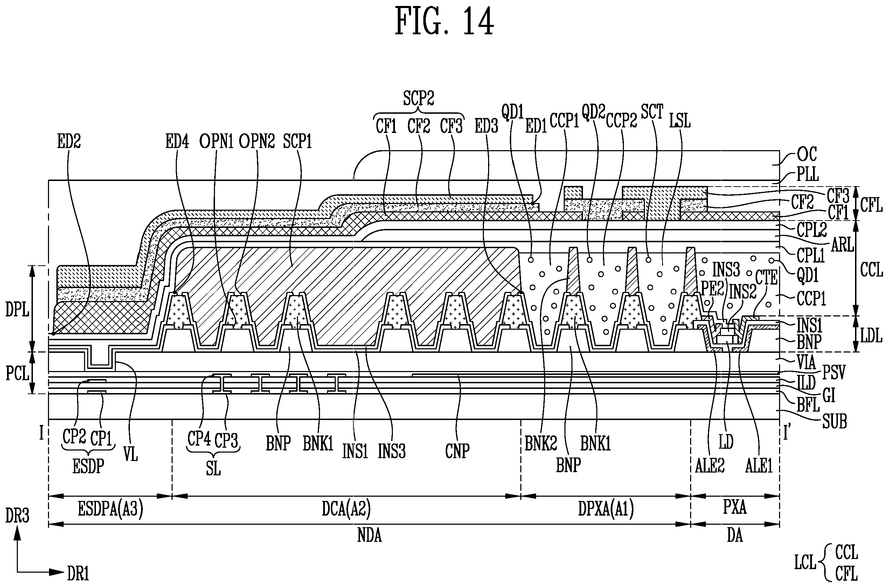

As illustrated in FIG. 14, the via layer VIA that is a common layer may include a valley VL that is formed by partially opening (or removing a portion of) the via layer VIA in the non-display area NDA. Although the via layer VIA formed of an organic insulating layer is desirable in terms of flexibility, elasticity, or the like, but is prone to penetration of water or oxygen compared to that of an inorganic insulating layer. Given the foregoing, insulating layers formed of inorganic insulating layers, e.g., the first and third insulating layers INS1 and INS3, may be formed on the via layer VIA to cover edges of the via layer VIA that oppose each other with the valley VL interposed therebetween, so that the edges of the via layer VIA can be prevented from being exposed. The valley VL may be located in the antistatic circuit area ESDPA of the display area NDA, and overlap the second step difference compensation pattern SCP2. The location of the valley VL is not limited to the foregoing. The valley VL may be located in the driving circuit area DCA, as illustrated in FIG. 15. In the driving circuit are DCA, the opposite edges (e.g., side surfaces opposing each other with the valley VL interposed therebetween) of the via layer VIA may be covered with the first and third insulating layers INS1 and INS3 without being exposed, and may be over the first and second step difference compensation patterns SCP1 and SCP2. In the case where the valley VL is located in the driving circuit area DCA, the valley VL may overlap the first step difference compensation pattern SCP1.

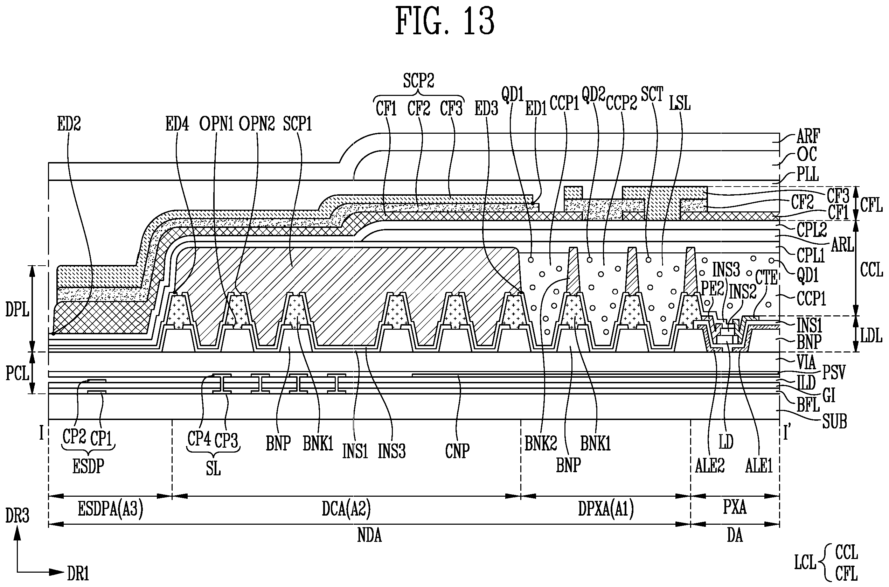

After the overcoat layer OC has been formed, the substrate SUB may be embodied on a cell basis by cutting a mother board through a cutting process. As illustrated in FIG. 13, an antireflection film ARF may be attached onto the substrate SUB that is embodied on a cell basis.

The antireflection film ARF may be attached onto the overcoat layer OC and the planarization layer PLL and coupled to the substrate SUB. The antireflection film ARF may reduce reflection of external light. For example, the antireflection film ARF may include a polarization film and/or a phase delay film. The number of phase delay films and a phase delay length of each phase delay film may be determined depending on the operation principle of the antireflection film ARF. The antireflection film ARF may be used as an encapsulation layer for preventing external water, oxygen, and the like from being drawn into the substrate SUB (or the display panel DP).

In the case where the antireflection film ARF is attached onto the substrate SUB that is embodied on a cell basis, a step difference between the antireflection film ARF and the components in the display area DA may be similar to a step difference between the antireflection film ARF and the components in the non-display area NDA because the first and second step difference compensation patterns SCP1 and SCP2 are disposed in the non-display area NDA. Hence, in the case where the antireflection film ARF is attached to the substrate SUB, a defect that may occur due to a step difference in the display area DA and the non-display area NDA (e.g., a gap that may be formed between the antireflection film ARF and components located therebelow) may be reduced or minimized. Consequently, the reliability of the display device DD may be enhanced.

In accordance with the foregoing, the first step difference compensation pattern SCP1 formed of the same material as that of the second bank BNK2 may be disposed in the non-display area NDA to control the flow rate of inkjet type material that is the base material of the low refractive layer ARL during a process of forming the low refractive layer ARL, so that the low refractive layer ARL can be formed in only a target area. Furthermore, the second step difference compensation pattern SCP2 may be disposed in the non-display area NDA and control the flow rate of inkjet type material that is base material of the overcoat layer OC during a process of forming the overcoat layer OC, so that the overcoat layer OC can be formed in only a target area. Therefore, a dam structure that is a separate component for preventing the inkjet type material from overflowing may be omitted, so that the efficiency of fabrication of the display device DD can be enhanced.

In the foregoing, the first and second capping layers CPL1 and CPL2 each of which is formed of an inorganic insulating layer may completely cover the first step difference compensation pattern SCP1, thus preventing external water, oxygen, and the like from being drawn into the first step difference compensation pattern SCP1.

In accordance with the foregoing, the valley VL may be formed in the via layer VIA, and the edges of the via layer VIA may be covered with an inorganic insulating layer so that external water, oxygen, and the like can be prevented from being drawn into the display area DA through the via layer VIA.

In accordance with the foregoing, an inorganic insulating layer, e.g., the first and third insulating layers INS1 and INS3, which are located over organic insulating layers, may be partially open so that the organic insulating layers can be connected to each other. Therefore, outgas generated from the organic insulating layers can be discharged to the second bank BNK2 and the second step difference compensation pattern SCP2. Hence, a separate process of forming a path for discharging outgas may be omitted, so that the efficiency of fabrication of the display device DD can be further enhanced.

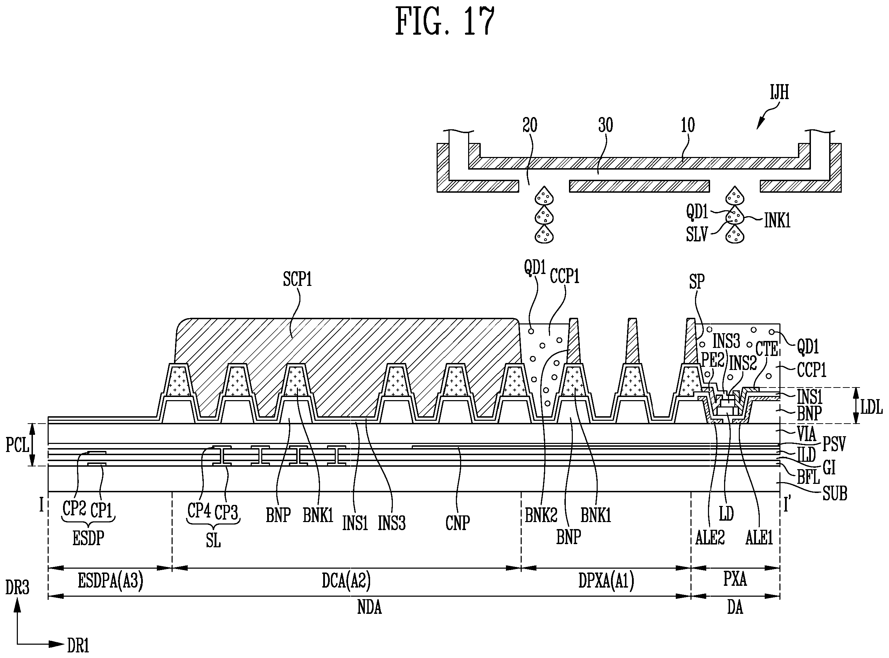

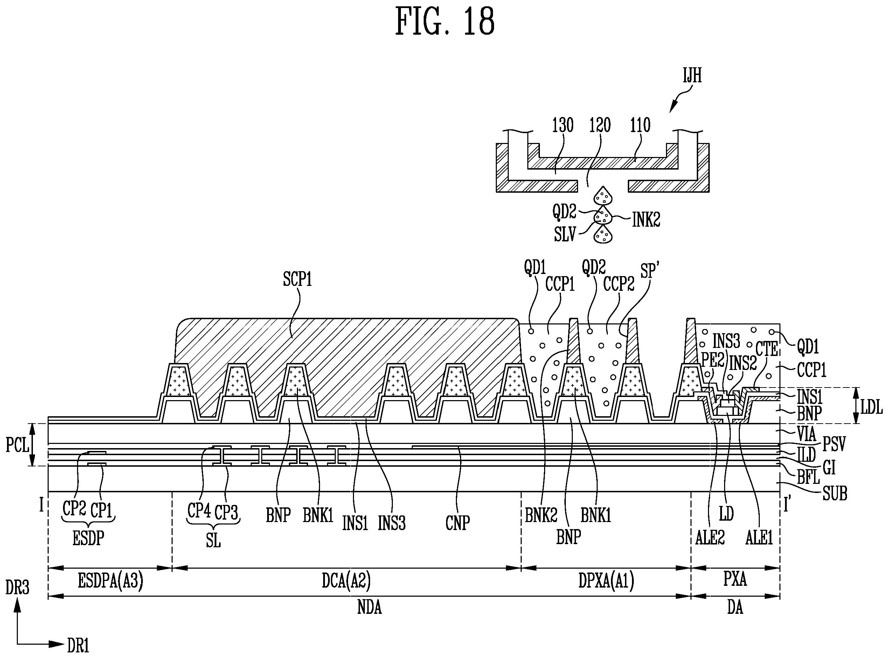

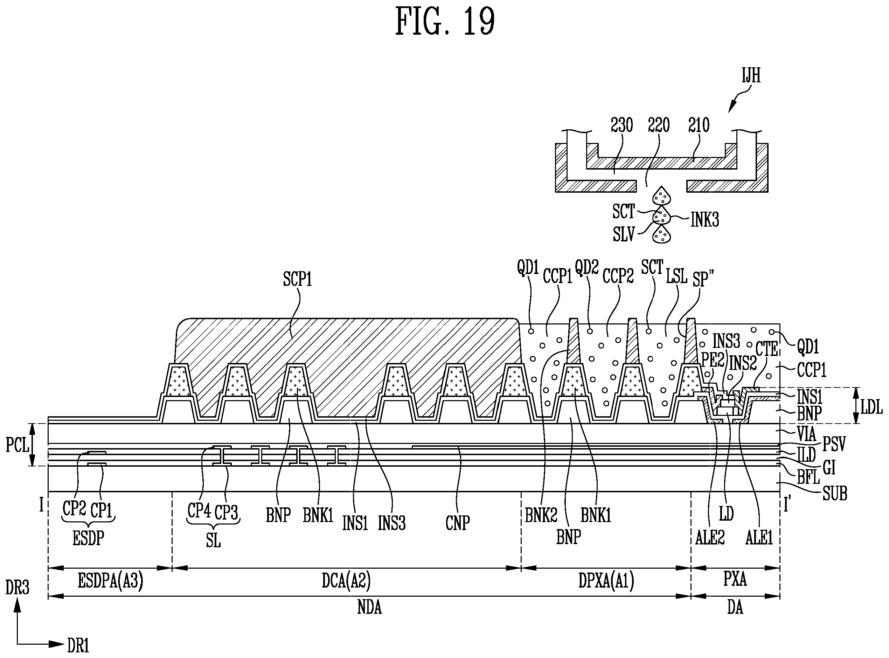

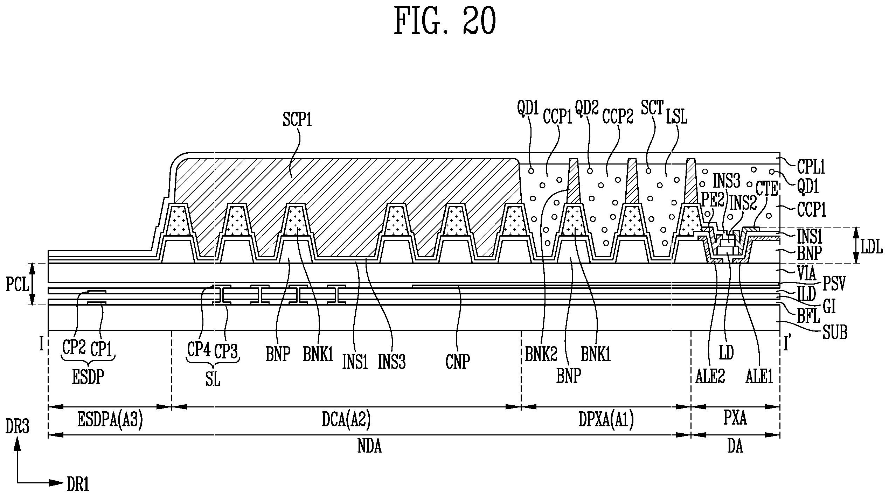

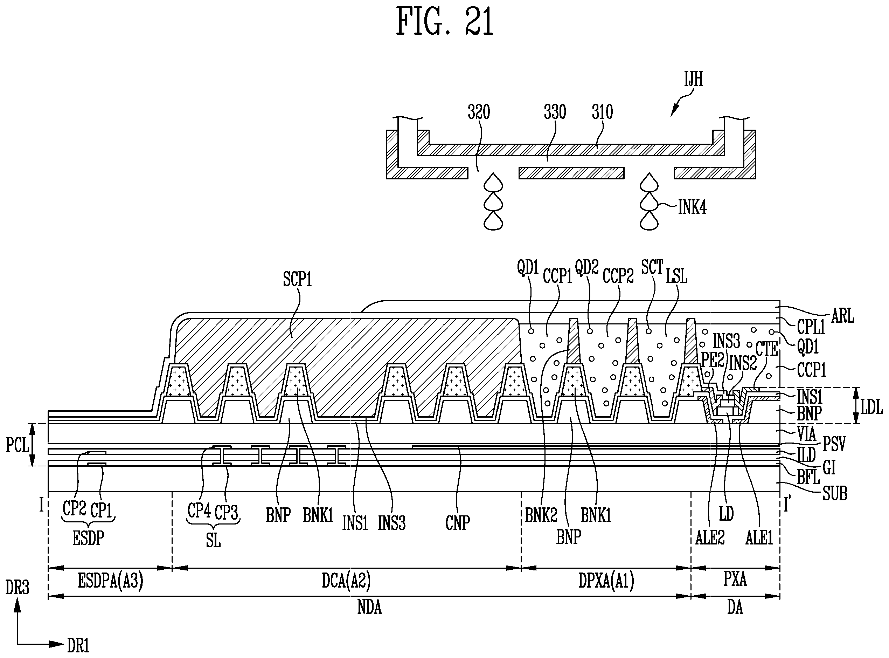

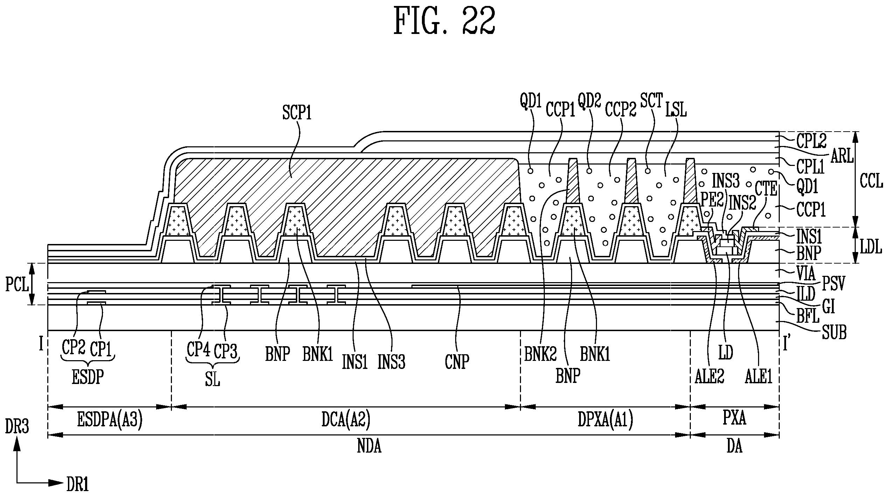

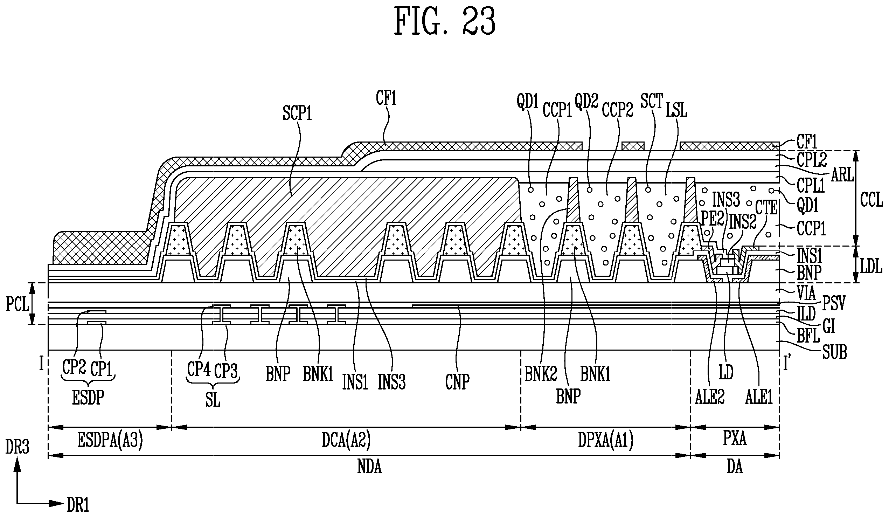

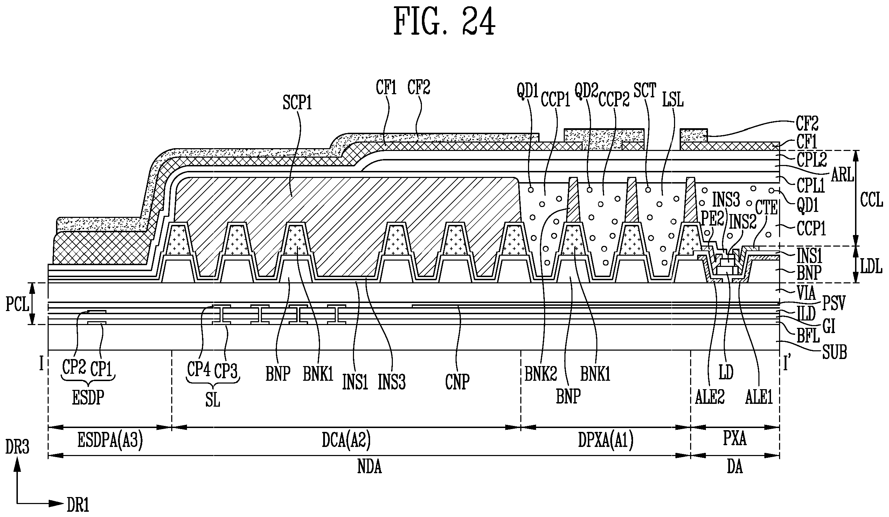

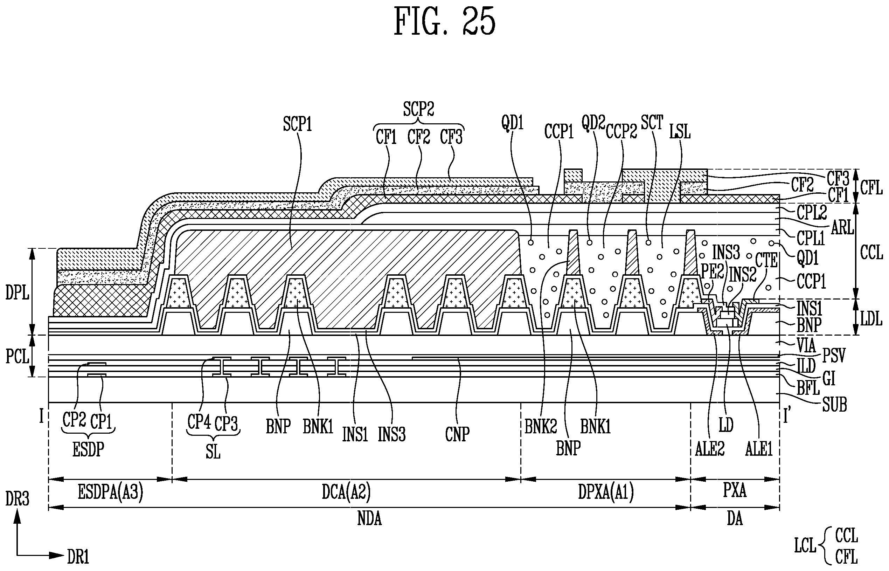

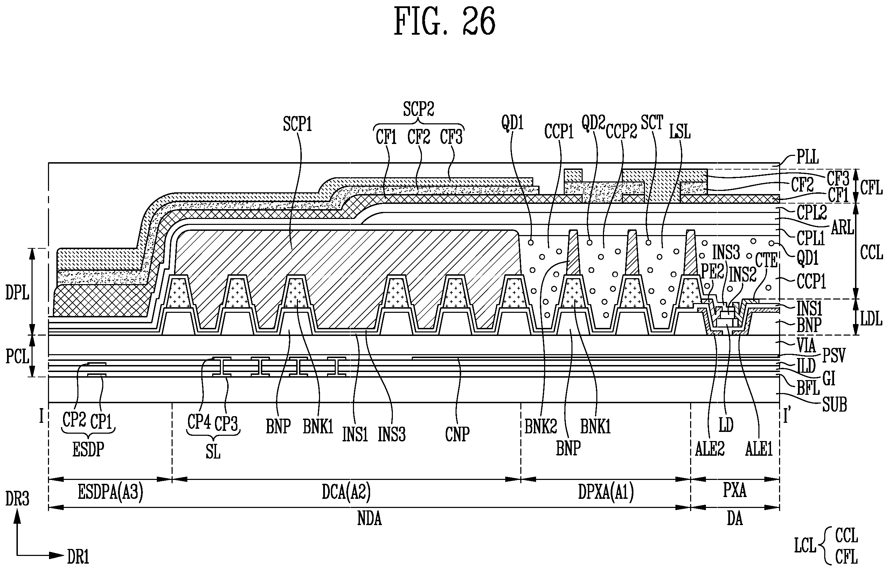

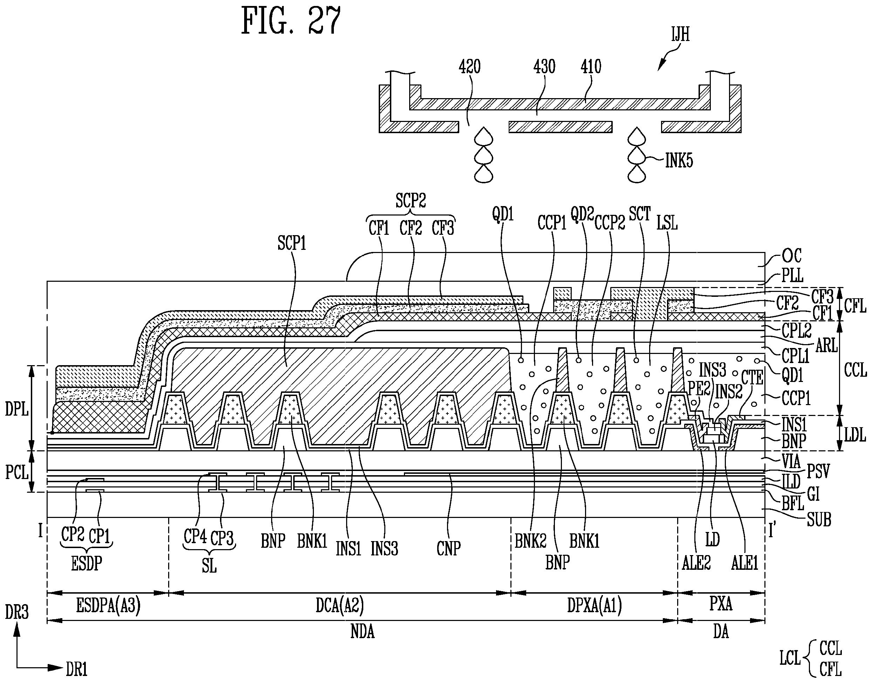

FIGS. 17 to 27 are views for describing a method of fabricating a display device according to the invention, and are schematic cross-sectional views corresponding to the line I-I' of FIG. 3.

There is illustrated the case where the steps of fabricating the display device DD are sequentially performed according to the sectional views, but without changing the technical scope of the present disclosure, some steps illustrated as being successively performed may be concurrently (e.g., simultaneously) performed, the sequence of the steps may be changed, some steps may be skipped, or an additional step may be further included between the steps.

The description with reference to FIGS. 17 to 27 will be focused on differences from the above-mentioned implementations so as to avoid redundant description.

Referring to FIGS. 3, 11, and 17, the second bank BNK2 may be formed on the pixel circuit layer PCL located in the display area DA. The second bank BNK2 and the first step difference compensation pattern SCP1 may be formed on the pixel circuit layer PCL located in the non-display area NDA. The second bank BNK2 may be located in the dummy pixel area DPXA in the non-display area NDA. The first step difference compensation pattern SCP1 may be located in the driving circuit area DCA in the non-display area NDA. The second bank BNK2 and the first step difference compensation pattern SCP1 may be formed through the same process and include the same material.

Thereafter, first ink INK1 may be supplied (or inputted) by the inkjet printing scheme to space SP enclosed by the second bank BNK2. The space SP may be an emission area of the first sub-pixel enclosed by the second bank BNK2.

An inkjet head unit IJH may be located over the second bank BNK2. The inkjet head unit IJH may include a print head 10, and at least one nozzle 20 located on a lower surface of the print head 10. The print head 10 may include an internal tube 30 formed in the direction in which the print head 10 extends. The nozzle 20 may be coupled to the internal tube 30 of the print head 10. The first ink INK1 including a solvent SLV and a plurality of first color conversion particles QD1 included (or dispersed) in the solvent SLV may be supplied to the internal tube 30. The first ink INK1 may flow along the internal tube 30 and then may be supplied to the space SP (or the emission area) enclosed by the second bank BNK2 through the nozzle 20.

After the first ink INK1 is supplied, the first ink INK1 is cured through a curing process such as a thermal curing process or an optical curing process, so that the first color conversion pattern CCP1 including the first color conversion particles QD1 can be formed at a preset location in each of the display area DA and the dummy pixel area DPXA.

Referring to FIGS. 3, 11, 17, and 18, second ink INK2 may be supplied (or inputted) by the inkjet printing scheme to additional space SP' enclosed by the second bank BNK2. The additional space SP' may be an emission area of the second sub-pixel enclosed by the second bank BNK2.

An additional inkjet head unit IJH may be located over the second bank BNK2. The additional inkjet head unit IJH may include a print head 110, and a nozzle 120 connected to an internal tube 130 of the print head 110. The second ink INK2 including a solvent SLV and a plurality of second color conversion particles QD2 included (or dispersed) in the solvent SLV may be supplied to the internal tube 130. The second ink INK2 may flow along the internal tube 130 and then may be supplied to the additional space SP' (or an additional emission area) enclosed by the second bank BNK2 through the nozzle 120.

After the second ink INK2 is supplied, the second ink INK2 is cured through a curing process, so that the second color conversion pattern CCP2 including the second color conversion particles QD2 can be formed at a preset location in each of the display area DA and the dummy pixel area DPXA.

Referring to FIGS. 3, 11, 17 to 19, third ink INK3 may be supplied (or inputted) by the inkjet printing scheme to further additional space SP" enclosed by the second bank BNK2. The further additional space SP" may be an emission area of the third sub-pixel enclosed by the second bank BNK2.

A further additional inkjet head unit IJH may be located over the second bank BNK2. The further additional inkjet head unit IJH may include a print head 210, and a nozzle 220 connected to an internal tube 230 of the print head 210. The third ink INK3 including a solvent SLV and a plurality of light scattering particles SCT included (or dispersed) in the solvent SLV may be supplied to the internal tube 230. The third ink INK3 may flow along the internal tube 230 and then may be supplied to the further additional space SP" (or a further additional emission area) enclosed by the second bank BNK2 through the nozzle 220.

After the third ink INK3 is supplied, the third ink INK3 is cured through a curing process, so that the light scattering layer LSL including the light scattering particles SCT can be formed at a preset location in each of the display area DA and the dummy pixel area DPXA.

Referring to FIGS. 3, 11, and 17 to 20, the first capping layer CPL1 may be formed in the display area DA and the non-display area NDA by a chemical vapor deposition method or the like.

The first capping layer CPL1 may be formed on the second bank BNK2, the first and second color conversion patterns CCP1 and CCP2, and the light scattering layer LSL in the display area DA and the dummy pixel area DPXA, may be formed on the first step difference compensation pattern SCP1 in the driving circuit area DCA, and may be formed on the third insulating layer INS3 in the antistatic circuit area ESDPA.

The first capping layer CPL1 may be an inorganic insulating layer including inorganic material. For example, the first capping layer CPL1 may include at least one of silicon nitride (SiNₓ), silicon oxide (SiOₓ), silicon oxynitride (SiOₓN_{y}), or aluminum oxide (AlOₓ). However, the material of the first capping layer CPL1 is not limited to the foregoing.

Referring to FIGS. 3, 11, and 17 to 21, fourth ink INK4 may be applied onto the first capping layer CPL1 of the display area DA and the non-display area NDA by the inkjet printing scheme.

A further additional inkjet head unit IJH may be located over the first capping layer CPL1. The further additional inkjet head unit IJH may include a print head 310, and a nozzle 320 connected to an internal tube 330 of the print head 310. The fourth ink INK4 may be supplied to the internal tube 330. The fourth ink INK4 may flow along the internal tube 330 and may be applied onto the first capping layer CPL1 disposed in the display area DA and the non-display area NDA through the nozzle 320. The fourth ink INK4 may include solids and a solvent. Here, the solids may include resin and hollow silica particles.

The fourth ink INK4 that is applied to the first capping layer CPL1 of the display area DA and the non-display area NDA may be provided to the entirety of the driving circuit area DCA. The flow rate of the fourth ink INK4 may be controlled by the first step difference compensation pattern SCP1 having a planar surface, so that the movement of the fourth ink INK4 can stop around a central portion of the driving circuit area DCA. Thereafter, the fourth ink INK4 is cured through a curing process such as a thermal curing process or an optical curing process, thus forming the low refractive layer ARL.

The low refractive layer ARL may be located in only the display area DA, the dummy pixel area DPXA, and a portion of the driving circuit area DCA, and may be located in neither the other portion of the driving circuit area DCA nor the antistatic circuit area ESDPA.

Referring to FIGS. 3, 11, and 17 to 22, the second capping layer CPL2 may be formed in the display area DA and the non-display area NDA by a chemical vapor deposition method or the like.

The second capping layer CPL2 may be formed on the low refractive layer ARL in the display area DA, the dummy pixel area DPXA, and a portion of the driving circuit area DCA, and may be located on the first capping layer CPL1 in the other portion of the driving circuit area DCA and the antistatic circuit area ESDPA.

The second capping layer CPL2 may be an inorganic insulating layer including inorganic material. For example, the second capping layer CPL2 may include at least one of silicon nitride (SiNₓ), silicon oxide (SiOₓ), silicon oxynitride (SiOₓN_{y}), or aluminum oxide (AlOₓ). However, the material of the second capping layer CPL2 is not limited to the foregoing.

Referring to FIGS. 3, 11, and 17 to 23, the first color filter pattern CF1 may be formed at a preset location of each of the display area DA and the non-display area NDA through a photolithography process or the like using a mask. For example, the first color filter pattern CF1 may be a red color filter.

In each of the display area DA and the dummy pixel area DPXA, the first color filter pattern CF1 may be formed on one surface of the second capping layer CPL2 to correspond to the first color conversion pattern CCP1. In the driving circuit area DCA, the first color filter pattern CF1 may be formed on one surface of the second capping layer CPL2 to overlap the first step difference compensation pattern SCP1. In the antistatic circuit area ESDPA, the first color filter pattern CF1 may be formed on one surface of the second capping layer CPL2.

Referring to FIGS. 3, 11, and 17 to 24, the second color filter pattern CF2 may be formed at a preset location of each of the display area DA and the non-display area NDA through a photolithography process or the like using a mask. For example, the second color filter pattern CF2 may be a green color filter.

In each of the display area DA and the dummy pixel area DPXA, the second color filter pattern CF2 may be formed on the second capping layer CPL2 to correspond to the second color conversion pattern CCP2. Furthermore, in each of the display area DA and the dummy pixel area DPXA, the second color filter pattern CF2 may be formed on the first color filter pattern CF1 located on the second capping layer CPL2 on the second bank BNK2. In the driving circuit area DCA and the antistatic circuit area ESDPA, the second color filter pattern CF2 may be formed on the first color filter pattern CF1.

Referring to FIGS. 3, 11, and 17 to 25, the third color filter pattern CF3 may be formed at a preset location of each of the display area DA and the non-display area NDA through a photolithography process or the like using a mask. The third color filter pattern CF3 may be a blue color filter.

In each of the display area DA and the dummy pixel area DPXA, the third color filter pattern CF3 may be formed on the second capping layer CPL2 to correspond to the light scattering layer LSL. Furthermore, in each of the display area DA and the dummy pixel area DPXA, the third color filter pattern CF3 may be formed on the first and second color filter patterns CF1 and CF2 that are successively stacked on the second capping layer CPL2 on the second bank BNK2. In the display area DA and the dummy pixel area DPXA, the first color filter pattern CF1, the second color filter pattern CF2, and the third color filter pattern CF3 that are successively stacked may be disposed to overlap each other and thus used as a light blocking component.

In the driving circuit area DCA and the antistatic circuit area ESDPA, the third color filter pattern CF3 may be formed on the second color filter pattern CF2. In the driving circuit area DCA and the antistatic circuit area ESDPA, the first color filter pattern CF1, the second color filter pattern CF2, and the third color filter pattern CF3 that are successively stacked may form the second step difference compensation pattern SCP2.

Referring to FIGS. 3, 11, and 17 to 26, the planarization layer PLL may be formed over the display area DA and the non-display area NDA by a chemical vapor deposition method or the like. The planarization layer PLL may cover the second end (refer to "ED2" of FIG. 11) of the second step difference compensation pattern SCP2 in the antistatic circuit area ESDPA.

Referring to FIGS. 3, 11, and 17 to 27, fifth ink INK5 may be applied onto the planarization layer PLL in the display area DA and the non-display area NDA by the inkjet printing scheme.

A further additional inkjet head unit IJH may be located over the planarization layer PLL. The further additional inkjet head unit IJH may include a print head 410, and a nozzle 420 connected to an internal tube 430 of the print head 410. The fifth ink INK5 may be supplied to the internal tube 430. The fifth ink INK5 may flow along the internal tube 430 and may be applied onto the planarization layer PLL disposed in the display area DA and the non-display area NDA through the nozzle 420.

The fifth ink INK5 that is applied to the planarization layer PLL in the display area DA and the non-display area NDA may be controlled in flow rate thereof by the planarization layer PLL and components, e.g., the first and second step difference compensation patterns SCP1 and SCP2, disposed under the planarization layer PLL, and the movement of the fifth ink INK5 may be stopped around the central portion of the driving circuit area DCA. Thereafter, the fifth ink INK5 is cured through a curing process such as a thermal curing process or an optical curing process, thus forming the overcoat layer OC.

Thereafter, although not directly illustrated in the drawings, a cutting process of dividing a mother board including the overcoat layer OC into cells may be performed, and a process of attaching the antireflection film (refer to "ARF" of FIG. 13) to substrates SUB divided from each other on a cell basis may be performed after the cutting process.

In the display device DD formed by the fabrication method described above, the first and second step difference compensation patterns SCP1 and SCP2 may be disposed in the non-display area NDA, so that a step difference between the antireflection film ARF and components disposed in the non-display area NDA can be mitigated, whereby a gap which may be caused in the case where the antireflection film ARF is attached to the components in the non-display area NDA can be reduced or minimized.

In one or more embodiments, a first step difference compensation pattern made of the same material as that of a second bank in a display area, and a second step difference compensation pattern made of a black matrix or the same material as that of the color filter layer in the display area may be disposed in a non-display area. The first step difference compensation pattern and the second step difference compensation pattern may mitigate a step difference between an antireflection film and components disposed in the non-display area. The first and second step difference compensation patterns may reduce or minimize a gap which may be formed in the case where the antireflection film is attached to the overcoat layer in the non-display area.

Therefore, a display device having improved reliability, and a method of fabricating the display device may be provided.

The effects, aspects, and features of the present disclosure are not limited by the foregoing, and other various effects, aspects, and features are anticipated herein.

While various example embodiments have been described above, those skilled in the art will appreciate that various modifications, additions and substitutions are possible, without departing from the scope of the present invention as defined by the claims.

## Claims

1. A display device (DD) comprising:
a substrate (SUB) comprising a display area (DA) including a pixel area (PXA), and a non-display area (NDA) at at least one side of the display area (DA);
a pixel (PXL) in the pixel area (PXA), and comprising a light emitting element (LD), a color conversion layer (CCL) located on the light emitting element (LD), and a color filter layer (CFL) located on the color conversion layer (CCL);
a first step difference compensation pattern (SCP1) in the non-display area (NDA), and around the display area (DA); and
a second step difference compensation pattern (SCP2) in the non-display area (NDA), and comprising a first end (ED1) adjacent to the display area (DA), and a second end (ED2) opposite to the first end (ED1) and located adjacent to an edge of the substrate (SUB),
wherein the second step difference compensation pattern (SCP2) is located on the first step difference compensation pattern (SCP1), overlaps the first step difference compensation pattern (SCP1) and covers one end of the first step difference compensation pattern (SCP1),
wherein the second step difference compensation pattern (SCP2) comprises the same material as the color filter layer (CFL), and
wherein each of the color filter layer (CFL) and the second step difference compensation pattern (SCP2) comprise a first color filter pattern (CF1), a second color filter pattern (CF2), and a third color filter pattern (CF3) that are successively stacked,
wherein the first color filter pattern (CF1) comprises a red color filter,
wherein the second color filter pattern (CF2) comprises a green color filter, and
wherein the third color filter pattern (CF3) comprises a blue color filter.

2. The display device according to claim 1,
wherein the first step difference compensation pattern comprises a third end (ED3) adjacent to the display area, and a fourth end (ED4) opposite to the third end,
wherein the first end of the second step difference compensation pattern is located closer to the display area than the third end of the first step difference compensation pattern, and
wherein the second end of the second step difference compensation pattern is located closer to the edge of the substrate than the fourth end of the first step difference compensation pattern, and covers the fourth end.

3. The display device according to claim 2,
wherein the non-display area includes a first area (A1) closest to the display area, a second area (A2) adjacent to the first area, and a third area (A3) adjacent to the second area and the edge of the substrate,
wherein a dummy pixel (DPXL) is located in the first area,
wherein signal lines are located in the second area, and
wherein an antistatic circuit (ESDP) is located in the third area.

4. The display device according to claim 3, wherein the first step difference compensation pattern is located in the second area and wherein the second step difference compensation pattern extends from the second area to the third area.

5. The display device according to claim 3 or 4, wherein the pixel comprises:
an emission area (EMA) and a non-emission area (NEA);
a transistor (T) and a via layer (VIA) on the substrate, the transistor being electrically connected to the light emitting element and the via layer covering the transistor;
a bank pattern (BNP) on the via layer and corresponding to at least the emission area;
a first alignment electrode (ALE1) and a second alignment electrode (ALE2) located on the bank pattern and spaced from each other;
a first insulating layer (INS1) on the first and the second alignment electrodes;
a first bank (BNK1) located in the non-emission area and including an opening (OPN1) corresponding to the emission area;
the light emitting element located in at least the emission area, and located on the first insulating layer between the first alignment electrode and the second alignment electrode;
a second insulating layer (INS2) located on the light emitting element and exposing the first end and the second end of the light emitting element;
a first electrode (PE1) and a second electrode (PE2) located in at least the emission area, and spaced from each other on the second insulating layer;
a third insulating layer (INS3) on the first and the second electrodes and the first bank;
the color conversion layer located on the third insulating layer and located in the emission area to correspond to the light emitting element, and comprising color conversion particles; and
a second bank (BNK2) on the first bank in the non-emission area, and around the color conversion layer.

6. The display device according to claim 5, wherein the first step difference compensation pattern comprises the same material as the second bank,
wherein the bank pattern and the first bank are in the display area, the first area, and the second area,
wherein the first and the third insulating layers are located from the display area to the first area, the second area, and the third area, and
wherein the first bank is located over the bank pattern with the first insulating layer interposed therebetween, and overlaps the bank pattern.

7. The display device according to claim 6,
wherein the first insulating layer includes a first opening (OPN1) exposing one area of the bank pattern, and
wherein the third insulating layer includes a second opening (OPN2) exposing one area of the first bank,
wherein the via layer comprises, in the third area, a valley (VL) formed by removing a portion of the via layer,
wherein the first insulating layer is over the valley and covers the valley, and
wherein the third insulating layer is on the first insulating layer, wherein the fourth end of the first step difference compensation pattern is located in the third area, and covers, in the second area, the first bank located closest to the third area.

8. The display device according to claim 7,
wherein the via layer comprises, in the second area, a valley (VL) formed by removing a portion of the via layer,
wherein the first insulating layer is over the valley and covers the valley,
wherein the third insulating layer is on the first insulating layer, and
wherein the first step difference compensation pattern overlaps the valley.

9. The display device according to claim 6, wherein the fourth end of the first step difference compensation pattern is located, in the second area, on the third insulating layer on the first bank located closest to the third area, and overlaps the first bank.

10. The display device according to any one of the preceding claims, wherein the second step difference compensation pattern comprises a black matrix.

11. The display device according to any one of claims 6 to 9, further comprising:
a first capping layer (CPL1) on the second bank and the color conversion layer;
a low refractive index layer (ARL) on the first capping layer;
a second capping layer (CPL2) on the low refractive layer;
a planarization layer (PLL) on the color filter layer; and
an overcoat layer (OC) on the planarization layer,
wherein the first capping layer, the second capping layer, and the planarization layer are in the display area, the first area, the second area, and the third area, and
wherein the low refractive index layer and the overcoat layer are in the display area, the first area, and the second area,
wherein an end of the low refractive index layer is located on one surface of the first capping layer on the first step difference compensation pattern in the second area, and
wherein an end of the overcoat layer is located on one surface of the planarization layer on the second step difference compensation pattern in the second area.

12. The display device according to claim 11, further comprising an antireflection film (ARF) on the overcoat layer and the planarization layer and coupled to the substrate.

13. A method of fabricating a display device (DD), comprising:
forming a substrate (SUB) including a display area (DA), and a non-display area (NDA) including a first area (A1) adjacent to the display area (DA), a second area (A2) adjacent to the first area (A1), and a third area (A3) adjacent to the second area (A2);
forming a first step difference compensation pattern (SCP1) on the substrate (SUB) in the second area, and forming a bank (BNK1) on the substrate (SUB) in each of the display area (DA) and the first area (A1), the bank (BNK1) comprising the same material as the first step difference compensation pattern (SCP1);
forming a color conversion layer (CCL) in a space enclosed by the bank (BNK1);
forming a first capping layer (CPL1) on the color conversion layer (CCL) and the first step difference compensation pattern (SCP1);
forming a low refractive layer (ARL) on the first capping layer (CPL1) of the display area (DA), the first capping layer (CPL1) of the first area (A1), and the first capping layer (CPL1) of the second area (A2) by an inkjet printing scheme;
forming a second capping layer (CPL2) on the low refractive layer (ARL) and the first capping layer (CPL1);
forming a color filter layer (CFL) on the second capping layer (CPL2) of each of the display area (DA) and the first area (A1), and forming, on the second capping layer (CPL2) of each of the second and the third areas (A2 and A3), a second step difference compensation pattern (SCP2) comprising the same material as the color filter layer (CFL);
forming a planarization layer (PLL) on the color filter layer (CFL) and the second step difference compensation pattern (SCP2); and
forming an overcoat layer (OC) on the planarization layer (PLL) of each of the display area (DA), the first area (A1), and the second area (A2) by an inkjet printing scheme,
wherein each of the color filter layer (CFL) and the second step difference compensation pattern (SCP2) comprise a first color filter pattern (CF1), a second color filter pattern (CF2), and a third color filter pattern (CF3) that are successively stacked,
wherein the first color filter pattern (CF1) comprises a red color filter,
wherein the second color filter pattern (CF2) comprises a green color filter, and
wherein the third color filter pattern (CF3) comprises a blue color filter.

## Patentansprüche

1. Anzeigevorrichtung (DD), umfassend:
ein Substrat (SUB), umfassend einen Anzeigebereich (DA), der einen Pixelbereich (PXA) und einen Nicht-Anzeigebereich (NDA) auf mindestens einer Seite des Anzeigebereichs (DA) aufweist;
ein Pixel (PXL) in dem Pixelbereich (PXA), und umfassend ein lichtemittierendes Element (LD), eine Farbumwandlungsschicht (CCL), die sich auf dem lichtemittierenden Element (LD) befindet, und eine Farbfilterschicht (CFL), die sich auf der Farbumwandlungsschicht (CCL) befindet;
ein erstes Stufendifferenz-Kompensationsmuster (SCP1) in dem Nicht-Anzeigebereich (NDA) und um den Anzeigebereich (DA) herum; und
ein zweites Stufendifferenz-Kompensationsmuster (SCP2) in dem Nicht-Anzeigebereich (NDA), und umfassend ein erstes Ende (ED1) angrenzend an den Anzeigebereich (DA) und ein zweites Ende (ED2) gegenüber dem ersten Ende (ED1) und das sich angrenzend an einen Rand des Substrats (SUB) befindet,
wobei das zweite Stufendifferenz-Kompensationsmuster (SCP2) auf dem ersten Stufendifferenz-Kompensationsmuster (SCP1) angeordnet ist, das erste Stufendifferenz-Kompensationsmuster (SCP1) überlappt und ein Ende des ersten Stufendifferenz-Kompensationsmusters (SCP1) bedeckt,
wobei das zweite Stufendifferenz-Kompensationsmuster (SCP2) das gleiche Material wie die Farbfilterschicht (CFL) umfasst, und
wobei die Farbfilterschicht (CFL) und das zweite Stufendifferenz-Kompensationsmuster (SCP2) jeweils ein erstes Farbfiltermuster (CF1), ein zweites Farbfiltermuster (CF2) und ein drittes Farbfiltermuster (CF3) umfassen, die nacheinander gestapelt sind,
wobei das erste Farbfiltermuster (CF1) einen Rot-Farbfilter umfasst,
wobei das zweite Farbfiltermuster (CF2) einen Grün-Farbfilter umfasst, und
wobei das dritte Farbfiltermuster (CF3) einen Blau-Farbfilter umfasst.

2. Anzeigevorrichtung nach Anspruch 1,
wobei das erste Stufendifferenz-Kompensationsmuster ein drittes Ende (ED3) angrenzend an den Anzeigebereich und ein viertes Ende (ED4) gegenüber dem dritten Ende umfasst, wobei das erste Ende des zweiten Stufendifferenz-Kompensationsmusters näher an dem Anzeigebereich angeordnet ist als das dritte Ende des ersten Stufendifferenz-Kompensationsmusters, und
wobei das zweite Ende des zweiten Stufendifferenz-Kompensationsmusters näher an dem Rand des Substrats angeordnet ist als das vierte Ende des ersten Stufendifferenz-Kompensationsmusters und das vierte Ende bedeckt.

3. Anzeigevorrichtung nach Anspruch 2,
wobei der Nicht-Anzeigebereich einen ersten Bereich (A1), der dem Anzeigebereich am nächsten ist, einen zweiten Bereich (A2), der an den ersten Bereich angrenzt, und einen dritten Bereich (A3), der an den zweiten Bereich und den Rand des Substrats angrenzt, beinhaltet,
wobei sich ein Dummy-Pixel (DPXL) in dem ersten Bereich befindet,
wobei sich Signalleitungen in dem zweiten Bereich befinden und
wobei sich eine antistatische Schaltung (ESDP) in dem dritten Bereich befindet.

4. Anzeigevorrichtung nach Anspruch 3, wobei sich das erste Stufendifferenz-Kompensationsmuster in dem zweiten Bereich befindet und wobei sich das zweite Stufendifferenz-Kompensationsmuster von dem zweiten Bereich zu dem dritten Bereich erstreckt.

5. Anzeigevorrichtung nach Anspruch 3 oder 4, wobei das Pixel Folgendes umfasst:
einen Emissionsbereich (EMA) und einen Nicht-Emissionsbereich (NEA);
einen Transistor (T) und eine Durchkontaktierungsschicht (VIA) auf dem Substrat, wobei der Transistor elektrisch mit dem lichtemittierenden Element verbunden ist und die Durchkontaktierungsschicht den Transistor bedeckt;
ein Bankmuster (BNP) auf der Durchkontaktierungsschicht, und das mindestens dem Emissionsbereich entspricht;
eine erste Ausrichtungselektrode (ALE1) und eine zweite Ausrichtungselektrode (ALE2), die sich auf dem Bankmuster befinden und voneinander beabstandet sind;
eine erste Isolierschicht (INS1) auf der ersten und der zweiten Ausrichtungselektrode;
eine erste Bank (BNK1), die sich in dem Nicht-Emissionsbereich befindet und eine Öffnung (OPN1) aufweist, die dem Emissionsbereich entspricht;
das lichtemittierende Element, das sich zumindest in dem Emissionsbereich befindet und sich auf der ersten Isolierschicht zwischen der ersten Ausrichtungselektrode und der zweiten Ausrichtungselektrode befindet;
eine zweite Isolierschicht (INS2), die sich auf dem lichtemittierenden Element befindet und das erste Ende und das zweite Ende des lichtemittierenden Elements freilegt;
eine erste Elektrode (PE1) und eine zweite Elektrode (PE2), die sich zumindest in dem Emissionsbereich befinden und auf der zweiten Isolierschicht voneinander beabstandet sind;
eine dritte Isolierschicht (INS3) auf der ersten und der zweiten Elektrode und der ersten Bank;
die Farbumwandlungsschicht, die sich auf der dritten Isolierschicht befindet und sich in dem Emissionsbereich befindet, um dem lichtemittierenden Element zu entsprechen, und umfassend Farbumwandlungspartikel; und
eine zweite Bank (BNK2) auf der ersten Bank in dem Nicht-Emissionsbereich und um die Farbumwandlungsschicht herum.

6. Anzeigevorrichtung nach Anspruch 5, wobei das erste Stufendifferenz-Kompensationsmuster das gleiche Material wie die zweite Bank umfasst,
wobei das Bankmuster und die erste Bank in dem Anzeigebereich, dem ersten Bereich und dem zweiten Bereich sind,
wobei sich die erste und die dritte Isolierschicht von dem Anzeigebereich zu dem ersten Bereich, dem zweiten Bereich und dem dritten Bereich befinden, und
wobei sich die erste Bank über dem Bankmuster befindet, wobei die erste Isolierschicht dazwischen eingefügt ist, und das Bankmuster überlappt.

7. Anzeigevorrichtung nach Anspruch 6,
wobei die erste Isolierschicht eine erste Öffnung (OPN1) beinhaltet, die einen Bereich des Bankmusters freilegt, und
wobei die dritte Isolierschicht eine zweite Öffnung (OPN2) beinhaltet, die einen Bereich der ersten Bank freilegt,
wobei die Durchkontaktierungsschicht in dem dritten Bereich ein Tal (VL) umfasst, das durch Entfernen eines Abschnitts der Durchkontaktierungsschicht gebildet wird,
wobei die erste Isolierschicht über dem Tal ist und das Tal bedeckt, und
wobei die dritte Isolierschicht auf der ersten Isolierschicht ist, wobei sich das vierte Ende des ersten Stufendifferenz-Kompensationsmusters in dem dritten Bereich befindet und in dem zweiten Bereich die erste Bank bedeckt, die dem dritten Bereich am nächsten ist.

8. Anzeigevorrichtung nach Anspruch 7,
wobei die Durchkontaktierungsschicht in dem zweiten Bereich ein Tal (VL) umfasst, das durch Entfernen eines Abschnitts der Durchkontaktierungsschicht gebildet wird,
wobei die erste Isolierschicht über dem Tal ist und das Tal bedeckt,
wobei die dritte Isolierschicht auf der ersten Isolierschicht ist und
wobei das erste Stufendifferenz-Kompensationsmuster das Tal überlappt.

9. Anzeigevorrichtung nach Anspruch 6, wobei sich das vierte Ende des ersten Stufendifferenz-Kompensationsmusters in dem zweiten Bereich auf der dritten Isolierschicht auf der ersten Bank befindet, die dem dritten Bereich am nächsten ist, und die erste Bank überlappt.

10. Anzeigevorrichtung nach einem der vorhergehenden Ansprüche, wobei das zweite Stufendifferenz-Kompensationsmuster eine schwarze Matrix umfasst.

11. Anzeigevorrichtung nach einem der Ansprüche 6 bis 9, ferner umfassend:
eine erste Abdeckschicht (CPL1) auf der zweiten Bank und der Farbumwandlungsschicht;
eine Schicht mit niedrigem Brechungsindex (ARL) auf der ersten Abdeckschicht;
eine zweite Abdeckschicht (CPL2) auf der niedrigbrechenden Schicht;
eine Planarisierungsschicht (PLL) auf der Farbfilterschicht; und
eine Überzugsschicht (OC) auf der Planarisierungsschicht,
wobei die erste Abdeckschicht, die zweite Abdeckschicht und die Planarisierungsschicht in dem Anzeigebereich, dem ersten Bereich, dem zweiten Bereich und dem dritten Bereich sind, und
wobei die Schicht mit niedrigem Brechungsindex und die Überzugsschicht in dem Anzeigebereich, in dem ersten Bereich und in dem zweiten Bereich sind,
wobei sich ein Ende der Schicht mit niedrigem Brechungsindex auf einer Oberfläche der ersten Abdeckschicht auf dem ersten Stufendifferenz-Kompensationsmuster in dem zweiten Bereich befindet, und
wobei sich ein Ende der Überzugsschicht auf einer Oberfläche der Planarisierungsschicht auf dem zweiten Stufendifferenz-Kompensationsmuster in dem zweiten Bereich befindet.

12. Anzeigevorrichtung nach Anspruch 11, ferner umfassend einen Antireflexionsfilm (ARF) auf der Überzugschicht und der Planarisierungsschicht und gekoppelt mit dem Substrat.

13. Verfahren zum Herstellen einer Anzeigevorrichtung (DD), umfassend:
Bilden eines Substrats (SUB), das den Anzeigebereich (DA) beinhaltet, und eines Nicht-Anzeigebereichs (NDA), das einen ersten Bereich (A1) angrenzend an den Anzeigebereich (DA), einen zweiten Bereich (A2) angrenzend an den ersten Bereich (A1) und einen dritten Bereich (A3) angrenzend an den zweiten Bereich (A2) beinhaltet;
Bilden eines ersten Stufendifferenz-Kompensationsmusters (SCP1) auf dem Substrat (SUB) in dem zweiten Bereich, und Bilden einer Bank (BNK1) auf dem Substrat (SUB) in jedem von dem Anzeigebereich (DA) und dem ersten Bereich (A1), die Bank (BNK1) umfassend das gleiche Material wie das erste Stufendifferenz-Kompensationsmuster (SCP1);
Bilden einer Farbumwandlungsschicht (CCL) in einem Raum, der von der Bank (BNK1) umschlossen ist;
Bilden einer ersten Abdeckschicht (CPL1) auf der Farbumwandlungsschicht (CCL) und dem ersten Stufendifferenz-Kompensationsmuster (SCP1);
Bilden einer niedrigbrechenden Schicht (ARL) auf der ersten Abdeckschicht (CPL1) des Anzeigebereichs (DA), der ersten Abdeckschicht (CPL1) des ersten Bereichs (A1) und der ersten Abdeckschicht (CPL1) des zweiten Bereichs (A2) durch ein Tintenstrahldruckschema;
Bilden einer zweiten Abdeckschicht (CPL2) auf der niedrigbrechenden Schicht (ARL) und der ersten Abdeckschicht (CPL1);
Bilden einer Farbfilterschicht (CFL) auf der zweiten Abdeckschicht (CPL2) von jedem von dem Anzeigebereich (DA) und dem ersten Bereich (A1), und Bilden, auf der zweiten Abdeckschicht (CPL2) von jedem von dem zweiten und dem dritten Bereich (A2 und A3), eines zweiten Stufendifferenz-Kompensationsmusters (SCP2), umfassend das gleiche Material wie die Farbfilterschicht (CFL);
Bilden einer Planarisierungsschicht (PLL) auf der Farbfilterschicht (CFL) und dem zweiten Stufendifferenz-Kompensationsmuster (SCP2); und
Bilden einer Überzugsschicht (OC) auf der Planarisierungsschicht (PLL) von jedem Anzeigebereich (DA), des ersten Bereichs (A1) und des zweiten Bereichs (A2) durch ein Tintenstrahldruckschema,
wobei jedes von der Farbfilterschicht (CFL) und dem zweiten Stufendifferenz-Kompensationsmuster (SCP2) jeweils ein erstes Farbfiltermuster (CF1), ein zweites Farbfiltermuster (CF2) und ein drittes Farbfiltermuster (CF3) umfassen, die nacheinander gestapelt sind,
wobei das erste Farbfiltermuster (CF1) einen Rot-Farbfilter umfasst,
wobei das zweite Farbfiltermuster (CF2) einen Grün-Farbfilter umfasst, und
wobei das dritte Farbfiltermuster (CF3) einen Blau-Farbfilter umfasst.

## Revendications

1. Dispositif d'affichage (DD), comprenant :
un substrat (SUB) comprenant une zone d'affichage (DA) comprenant une zone de pixels (PXA) et une zone de non-affichage (NDA) sur au moins un côté de la zone d'affichage (DA) ;
un pixel (PXL) dans la zone de pixels (PXA), et comprenant un élément électroluminescent (LD), une couche de conversion de couleur (CCL) située sur l'élément électroluminescent (LD), et une couche de filtre de couleur (CFL) située sur la couche de conversion de couleur (CCL) ;
un premier motif de compensation de différence de pas (SCP1) dans la zone de non-affichage (NDA) et autour de la zone d'affichage (DA) ; et
un deuxième motif de compensation de différence de pas (SCP2) dans la zone de non-affichage (NDA), et comprenant une première extrémité (ED1) adjacente à la zone d'affichage (DA) et une deuxième extrémité (ED2) opposée à la première extrémité (ED1) et située adjacente à un bord du substrat (SUB),
ledit deuxième motif de compensation de différence de pas (SCP2) étant situé sur le premier motif de compensation de différence de pas (SCP1), chevauchant le premier motif de compensation de différence de pas (SCP1) et couvrant une extrémité du premier motif de compensation de différence de pas (SCP1),
ledit deuxième motif de compensation de différence de pas (SCP2) comprenant le même matériau que la couche de filtre de couleur (CFL), et
ladite couche de filtre de couleur (CFL) et ledit deuxième motif de compensation de différence de pas (SCP2) comprenant chacun un premier motif de filtre de couleur (CF1), un deuxième motif de filtre de couleur (CF2) et un troisième motif de filtre de couleur (CF3) qui sont successivement empilés,
ledit premier motif de filtre de couleur (CF1) comprenant un filtre de couleur rouge,
ledit deuxième motif de filtre de couleur (CF2) comprenant un filtre de couleur verte, et
ledit troisième motif de filtre de couleur (CF3) comprenant un filtre de couleur bleue.

2. Dispositif d'affichage selon la revendication 1,
ledit premier motif de compensation de différence de pas comprenant une troisième extrémité (ED3) adjacente à la zone d'affichage et une quatrième extrémité (ED4) opposée à la troisième extrémité,
ladite première extrémité du deuxième motif de compensation de différence de pas étant située plus près de la zone d'affichage que la troisième extrémité du premier motif de compensation de différence de pas, et
ladite deuxième extrémité du deuxième motif de compensation de différence de pas étant située plus près du bord du substrat que la quatrième extrémité du premier motif de compensation de différence de pas, et couvrant la quatrième extrémité.

3. Dispositif d'affichage selon la revendication 2,
ladite zone de non-affichage comprenant une première zone (A1) la plus proche de la zone d'affichage, une deuxième zone (A2) adjacente à la première zone et une troisième zone (A3) adjacente à la deuxième zone et au bord du substrat,
un pixel factice (DPXL) étant situé dans la première zone,
des lignes de signal étant situées dans la deuxième zone, et
un circuit antistatique (ESDP) étant situé dans la troisième zone.

4. Dispositif d'affichage selon la revendication 3, ledit premier motif de compensation de différence de pas étant situé dans la deuxième zone et ledit deuxième motif de compensation de différence de pas s'étendant de la deuxième zone à la troisième zone.

5. Dispositif d'affichage selon la revendication 3 ou 4, ledit pixel comprenant :
une zone d'émission (EMA) et une zone de non-émission (NEA) ;
un transistor (T) et une couche de trous d'interconnexion (VIA) sur le substrat, le transistor étant connecté électriquement à l'élément électroluminescent et la couche de trous d'interconnexion recouvrant le transistor ;
un motif de banc (BNP) sur la couche de trous d'interconnexion et correspondant au moins à la zone d'émission ;
une première électrode d'alignement (ALE1) et une seconde électrode d'alignement (ALE2) situées sur le motif de banc et espacées l'une de l'autre ;
une première couche isolante (INS 1) sur les première et seconde électrodes d'alignement ;
un premier banc (BNK1) situé dans la zone de non-émission et comprenant une ouverture (OPN1) correspondant à la zone d'émission ;
l'élément électroluminescent situé dans au moins la zone d'émission et situé sur la première couche isolante entre la première électrode d'alignement et la seconde électrode d'alignement ;
une deuxième couche isolante (INS2) située sur l'élément électroluminescent et exposant la première extrémité et la seconde extrémité de l'élément électroluminescent ;
une première électrode (PE1) et une seconde électrode (PE2) situées au moins dans la zone d'émission et espacées l'une de l'autre sur la deuxième couche isolante ;
une troisième couche isolante (INS3) sur les première et seconde électrodes et le premier banc ;
la couche de conversion de couleur située sur la troisième couche isolante et située dans la zone d'émission pour correspondre à l'élément électroluminescent, et comprenant des particules de conversion de couleur ; et
un second banc (BNK2) sur le premier banc dans la zone de non-émission et autour de la couche de conversion de couleur.

6. Dispositif d'affichage selon la revendication 5, le premier motif de compensation de différence de pas comprenant le même matériau que le second banc,
ledit motif de banc et ledit premier banc étant dans la zone d'affichage, la première zone et la deuxième zone,
lesdites première et troisième couches isolantes étant situées de la zone d'affichage à la première zone, la deuxième zone et la troisième zone, et
ledit premier banc étant situé sur le motif de banc avec la première couche isolante interposée entre eux, et chevauchant le motif de banc.

7. Dispositif d'affichage selon la revendication 6,
ladite première couche isolante comprenant une première ouverture (OPN1) exposant une zone du motif de banc, et
ladite troisième couche isolante comprenant une seconde ouverture (OPN2) exposant une zone du premier banc,
ladite couche de trous d'interconnexion comprenant, dans la troisième zone, une vallée (VL) formée en retirant une partie de la couche de trous d'interconnexion,
ladite première couche isolante étant au-dessus de la vallée et recouvrant la vallée, et
ladite troisième couche isolante étant sur la première couche isolante, ladite quatrième extrémité du premier motif de compensation de différence de pas étant située dans la troisième zone et couvrant, dans la deuxième zone, le premier banc situé le plus près de la troisième zone.

8. Dispositif d'affichage selon la revendication 7,
ladite couche de trous d'interconnexion comprenant, dans la deuxième zone, une vallée (VL) formée en retirant une partie de la couche de trous d'interconnexion,
ladite première couche isolante étant au-dessus de la vallée et recouvrant la vallée,
ladite troisième couche isolante étant sur la première couche isolante et
ledit premier motif de compensation de différence de pas chevauchant la vallée.

9. Dispositif d'affichage selon la revendication 6, ladite quatrième extrémité du premier motif de compensation de différence de pas étant située, dans la deuxième zone, sur la troisième couche isolante sur le premier banc situé le plus près de la troisième zone, et chevauchant le premier banc.

10. Dispositif d'affichage selon l'une quelconque des revendications précédentes, ledit deuxième motif de compensation de différence de pas comprenant une matrice noire.

11. Dispositif d'affichage selon l'une quelconque des revendications 6 à 9, comprenant en outre :
une première couche de recouvrement (CPL1) sur le second banc et la couche de conversion de couleur ;
une couche à faible indice de réfraction (ARL) sur la première couche de recouvrement ;
une seconde couche de recouvrement (CPL2) sur la couche à faible réfraction ;
une couche de planarisation (PLL) sur la couche de filtre de couleur ; et
une surcouche (OC) sur la couche de planarisation,
ladite première couche de recouvrement, ladite seconde couche de recouvrement et ladite couche de planarisation étant dans la zone d'affichage, la première zone, la deuxième zone et la troisième zone, et
ladite couche à faible indice de réfraction et ladite surcouche étant dans la zone d'affichage, la première zone et la deuxième zone,
une extrémité de la couche à faible indice de réfraction étant située sur une surface de la première couche de recouvrement sur le premier motif de compensation de différence de pas dans la deuxième zone, et
une extrémité de la surcouche étant située sur une surface de la couche de planarisation sur le deuxième motif de compensation de différence de pas dans la deuxième zone.

12. Dispositif d'affichage selon la revendication 11, comprenant en outre un film antireflet (ARF) situé sur la surcouche et la couche de planarisation et couplé au substrat.

13. Procédé de fabrication d'un dispositif d'affichage (DD), comprenant :
la formation d'un substrat (SUB) comprenant une zone d'affichage (DA) et une zone de non-affichage (NDA) comprenant une première zone (A1) adjacente à la zone d'affichage (DA), une deuxième zone (A2) adjacente à la première zone (A1) et une troisième zone (A3) adjacente à la deuxième zone (A2) ;
la formation d'un premier motif de compensation de différence de pas (SCP1) sur le substrat (SUB) dans la deuxième zone, et la formation d'un banc (BNK1) sur le substrat (SUB) dans chacune de la zone d'affichage (DA) et de la première zone (A1), le banc (BNK1) comprenant le même matériau que le premier motif de compensation de différence de pas (SCP1) ;
la formation d'une couche de conversion de couleur (CCL) dans un espace entouré par le banc (BNK1) ;
la formation d'une première couche de recouvrement (CPL1) sur la couche de conversion de couleur (CCL) et le premier motif de compensation de différence de pas (SCP1) ;
la formation d'une couche à faible réfraction (ARL) sur la première couche de recouvrement (CPL1) de la zone d'affichage (DA), la première couche de recouvrement (CPL1) de la première zone (A1) et la première couche de recouvrement (CPL1) de la deuxième zone (A2) par un schéma d'impression à jet d'encre ;
la formation d'une seconde couche de recouvrement (CPL2) sur la couche à faible réfraction (ARL) et la première couche de recouvrement (CPL1) ;
la formation d'une couche de filtre de couleur (CFL) sur la seconde couche de recouvrement (CPL2) de chacune de la zone d'affichage (DA) et de la première zone (A1), et la formation, sur la seconde couche de recouvrement (CPL2) de chacune de la deuxième et de la troisième zone (A2 et A3), d'un deuxième motif de compensation de différence de pas (SCP2) comprenant le même matériau que la couche de filtre de couleur (CFL) ;
la formation d'une couche de planarisation (PLL) sur la couche de filtre de couleur (CFL) et le deuxième motif de compensation de différence de pas (SCP2) ; et
la formation d'une surcouche (OC) sur la couche de planarisation (PLL) de chacune de la zone d'affichage (DA), de la première zone (A1) et de la deuxième zone (A2) par un schéma d'impression à jet d'encre, ladite couche de filtre de couleur (CFL) et ledit deuxième motif de compensation de différence de pas (SCP2) comprenant chacun un premier motif de filtre de couleur (CF1), un deuxième motif de filtre de couleur (CF2) et un troisième motif de filtre de couleur (CF3) qui sont successivement empilés,
ledit premier motif de filtre de couleur (CF1) comprenant un filtre de couleur rouge, ledit deuxième motif de filtre de couleur (CF2) comprenant un filtre de couleur verte, et ledit troisième motif de filtre de couleur (CF3) comprenant un filtre de couleur bleue.
